# EUROPEAN PATENT SPECIFICATION

(11) **EP 4 416 157 B1**
(45) Date of publication and mention of the grant of the patent: **02.12.2026**
(21) Application number: 22881384.6
(22) Date of filing: 13.10.2022
(51) Int. Cl.: C07F 5/02, H10K 85/60

(54) **ORGANIC MOLECULES FOR OPTOELECTRONIC DEVICES**
ORGANISCHE MOLEKÜLE FÜR OPTOELEKTRONISCHE VORRICHTUNGEN
MOLÉCULES ORGANIQUES POUR DISPOSITIFS OPTOÉLECTRONIQUES

(30) Priority: 15.10.2021 EP 21203031
(43) Date of publication of application: 21.08.2024
(73) Proprietor: Samsung Display Co., Ltd., Yongin-si, Gyeonggi-do 17113 (KR)
(72) Inventor: DÜCK, Sebastian, 69115 Heidelberg (DE)
(74) Representative: Marks & Clerk LLP
(86) International application number: PCT/KR2022/015533
(87) International publication number: WO 2023/063757

(56) References cited:
- WO-A1-2021/077810
- CN-A- 111 377 955
- CN-A- 112 279 872
- KR-A- 20210 111 091
- US-A1- 2020 185 626
- US-A1- 2021 126 196
- DATABASE REAXYS [online] 1 January 2020 (2020-01-01), SAMSUNG DISPLAY: "ORGANIC ELECTROLUMINESCENCE DEVICE AND POLYCYCLIC COMPOUND FOR ORGANIC ELECTROLUMINESCENCE DEVICE - US2020/185626 A1", XP093293534, Database accession no. US2020/185626 A1

## Description

### [Technical Field]

The invention relates to light-emitting organic molecules and to oligomers comprising a plurality of such organic molecules as oligomer units and their use in organic light-emitting diodes (OLEDs) and in other optoelectronic devices.

### [Background Art]

US 2020/185626 A1 relates to an organic electroluminescence device and a polycyclic compound for an organic electroluminescence device.

### [Disclosure]

### [Technical Problem]

The object of the present invention is to provide molecules which are suitable for use in optoelectronic devices.

### [Technical Solution]

This object is achieved by the invention which provides a new class of organic molecules.

According to the invention, the organic molecules are purely organic molecules, i.e. they do not contain any metal ions in contrast to metal complexes known for the use in optoelectronic devices. The organic molecules of the invention, however, include metalloids, in particular B, Si, Sn, Se, and/or Ge.

According to the present invention, the organic molecules exhibit emission maxima in the yellow, orange or red spectral range. The organic molecules exhibit in particular emission maxima between 570 nm and 800 nm, preferably between 580 nm and 700 nm, more preferably between 590 nm and 690 nm, and even more preferably between 610 nm and 665 nm. The photoluminescence quantum yields of the organic molecules according to the invention are, in particular, 30 % or more. The use of the molecules according to the invention in an optoelectronic device, for example an organic light-emitting diode (OLED), leads to higher efficiencies or higher color purity, expressed by the full width at half maximum (FWHM) of emission, of the device. Corresponding OLEDs have a higher stability than OLEDs with known emitter materials and comparable color.

### Organic molecules according to the invention

The invention refers in a first aspect to organic molecules comprising or consisting of a structure of Formula I: 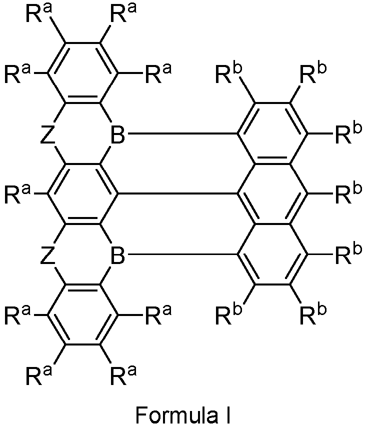
Z is at each occurrence independently selected from the group consisting of a direct bond, NR^{a}, O, and S;
R^{a} and R^{b} are at each occurrence independently selected from the group consisting of: hydrogen, deuterium, N(R⁵)₂, OR⁵, Si(R⁵)₃, B(OR⁵)₂, B(R⁵)₂, OSO₂R⁵, CF₃, CN, F, Br, I, C₁-C₄₀-alkyl,
   which is optionally substituted with one or more R⁵ substituents and
   wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₁-C₄₀-alkoxy,
   which is optionally substituted with one or more R⁵ substituents and
   wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₁-C₄₀-thioalkoxy,
   which is optionally substituted with one or more R⁵ substituents and
   wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₂-C₄₀-alkenyl,
   which is optionally substituted with one or more R⁵ substituents and
   wherein one or more non-adjacent CH₂-groups are optionally substituted by R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₂-C₄₀-alkynyl,
   which is optionally substituted with one or more R⁵ substituents and
   wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₆-C₆₀-aryl,
   which is optionally substituted with one or more R⁵ substituents; and
C₂-C₅₇-heteroaryl,
   which is optionally substituted with one or more R⁵ substituents;
R⁵ is at each occurrence independently selected from the group consisting of: hydrogen, deuterium, N(R⁶)₂, OR⁶, Si(R⁶)₃, B(OR⁶)₂, B(R⁶)₂, OSO₂R⁶, CF₃, CN, F, Br, I,
C₁-C₄₀-alkyl,
   which is optionally substituted with one or more R⁶ substituents and
   wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₁-C₄₀-alkoxy,
   which is optionally substituted with one or more R⁶ substituents and
   wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₁-C₄₀-thioalkoxy,
   which is optionally substituted with one or more R⁶ substituents and
   wherein one or more non-adjacent CH₂-groups are optionally substituted by R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₂-C₄₀-alkenyl,
   which is optionally substituted with one or more R⁶ substituents and
   wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₂-C₄₀-alkynyl,
   which is optionally substituted with one or more R⁶ substituents and
   wherein one or more non-adjacent CH₂-groups are optionally substituted by R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₆-C₆₀-aryl,
   which is optionally substituted with one or more R⁶ substituents; and
C₂-C₅₇-heteroaryl,
   which is optionally substituted with one or more R⁶ substituents;
R⁶ is at each occurrence independently selected from the group consisting of: hydrogen, deuterium, OPh (Ph = phenyl), CF₃, CN, F,
C₁-C₅-alkyl,
   wherein one or more hydrogen atoms are optionally, independently substituted by deuterium, CN, CF₃, or F;
C₁-C₅-alkoxy,
   wherein one or more hydrogen atoms are optionally, independently substituted by deuterium, CN, CF₃, or F;
C₁-C₅-thioalkoxy,
   wherein one or more hydrogen atoms are optionally, independently substituted by deuterium, CN, CF₃, or F;
C₂-C₅-alkenyl,
   wherein one or more hydrogen atoms are optionally, independently substituted by deuterium, CN, CF₃, or F;
C₂-C₅-alkynyl,
   wherein one or more hydrogen atoms are optionally, independently substituted by deuterium, CN, CF₃, or F;
C₆-C₁₈-aryl,
   which is optionally substituted with one or more C₁-C₅-alkyl substituents; C₂-C₁₇-heteroaryl,
   which is optionally substituted with one or more C₁-C₅-alkyl substituents; N(C₆-C₁₈-aryl)₂;
N(C₂-C₁₇-heteroaryl)₂, and
N(C₂-C₁₇-heteroaryl)(C₆-C₁₈-aryl);
wherein any of the substituents R^{a}, R^{b}, R⁵, and R⁶ may independently form a mono- or polycyclic, aliphatic, aromatic, heteroaromatic and/or benzo-fused ring system with one or more substituents R^{a}, R^{b}, R⁵ and/or R⁶.

In one embodiment, the organic molecules comprise or consist of a structure of formula la, formula Ib or formula Ic: 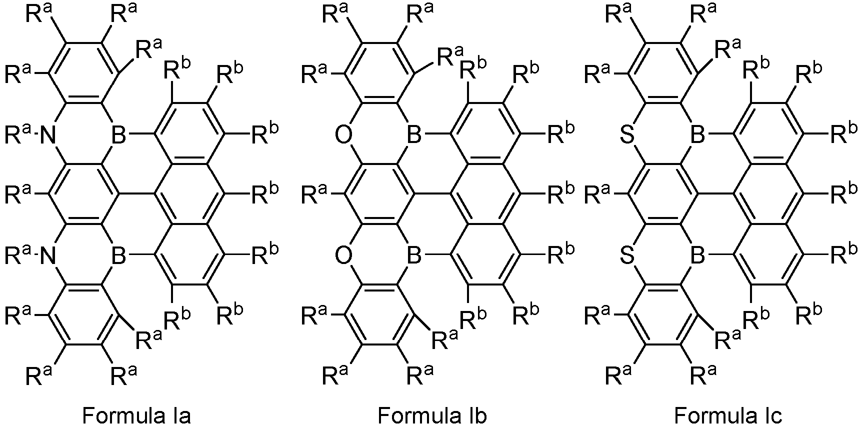 wherein, in Formula la, Formula Ib and Formula Ic, R^{a} and R^{b} are the same as described in connection with Formula I.

In one embodiment, the organic molecules comprise or consist of a structure of formula Id, formula le or formula If: 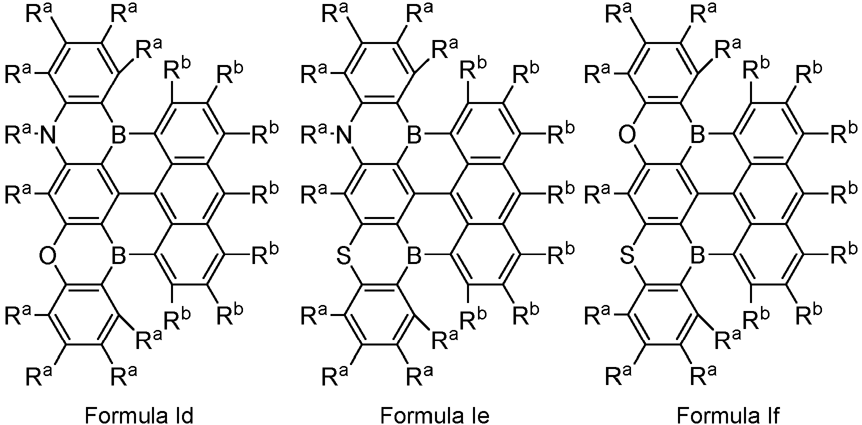 wherein, in Formula Id, Formula le and Formula If, R^{a} and R^{b} are the same as described in connection with Formula I.

In a preferred embodiment, Z is at each occurrence independently selected from the group consisting of NR^{a} and O.

In a preferred embodiment, the organic molecules comprise or consist of a structure of formula II-1 or formula II-2: 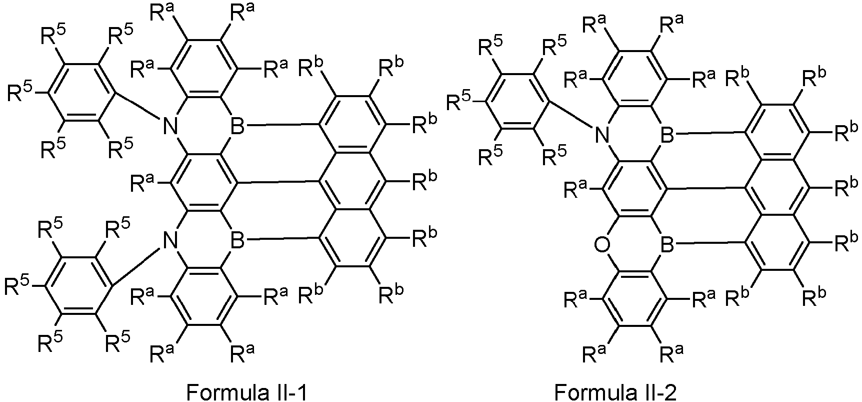 wherein, in Formula II-1 and Formula II-2, R^{a}, R^{b}, and R⁵ are the same as described in connection with Formula I.

In one embodiment, the organic molecules comprise or consist of a structure of formula IIa: 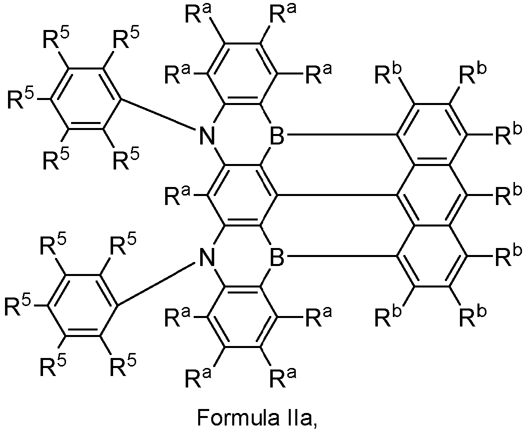 wherein, in Formula Ila, R^{a}, R^{b}, and R⁵ are the same as described in connection with Formula I.

In one embodiment of the invention, R^{a} is at each occurrence independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

In one embodiment of the invention, R⁵ is at each occurrence independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

In one embodiment, the organic molecules comprise or consist of a structure of formula Ila-1: 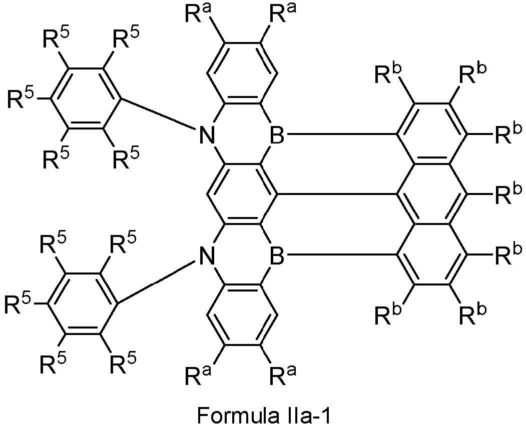 wherein, in Formula Ila-1, R^{a}, R^{b}, and R⁵ are the same as described in connection with Formula I.

In one embodiment, the organic molecules comprise or consist of a structure of formula Ila-2, formula Ila-3, formula Ila-4 or formula Ila-5: 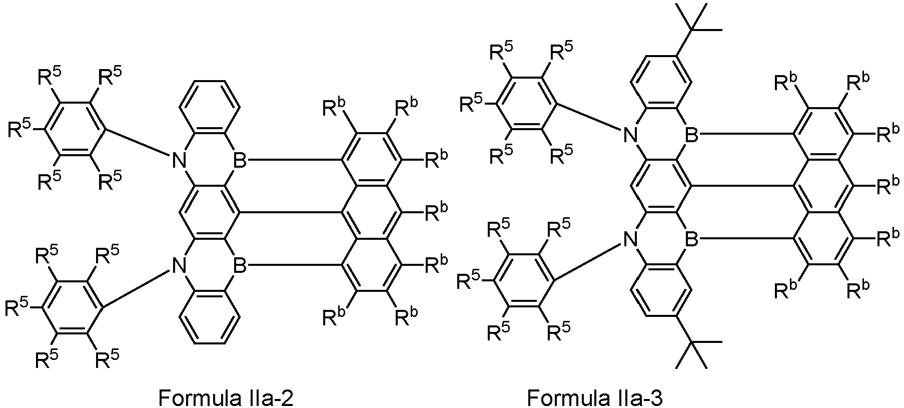 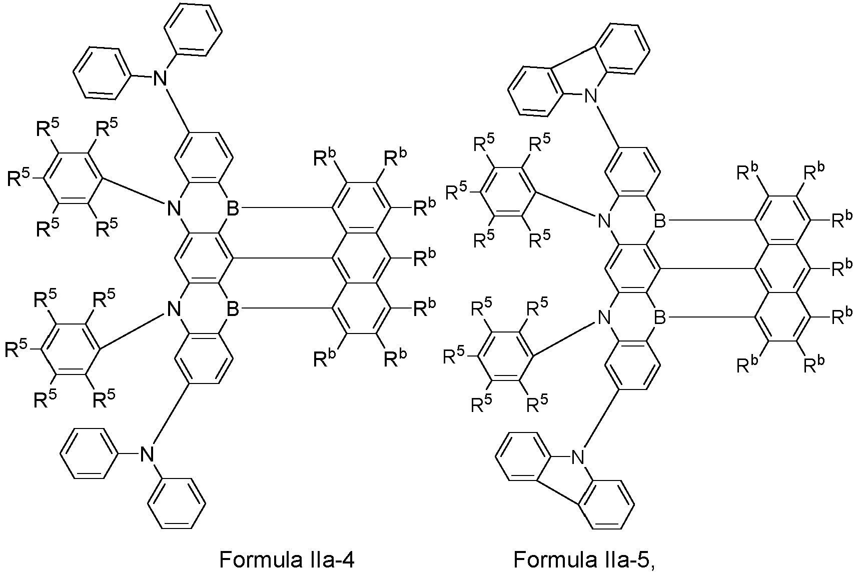 wherein, in Formula Ila-2, Formula Ila-3, Formula Ila-4 and Formula Ila-5, R^{b} and R⁵ are the same as described in connection with Formula I.

In one embodiment, the organic molecules comprise or consist of a structure formula Ila-1, wherein adjacent R^{a} substituents independently form a mono- or polycyclic, aliphatic, aromatic, heteroaromatic and/or benzo-fused ring system.

In one embodiment, the organic molecules comprise or consist of a structure of formula Ilb-1, formula Ilb-2, formula Ilb-3 or formula Ilb-4: 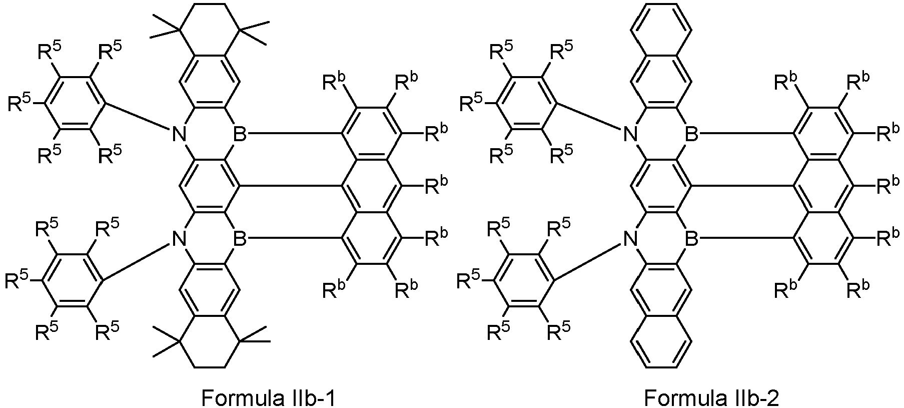 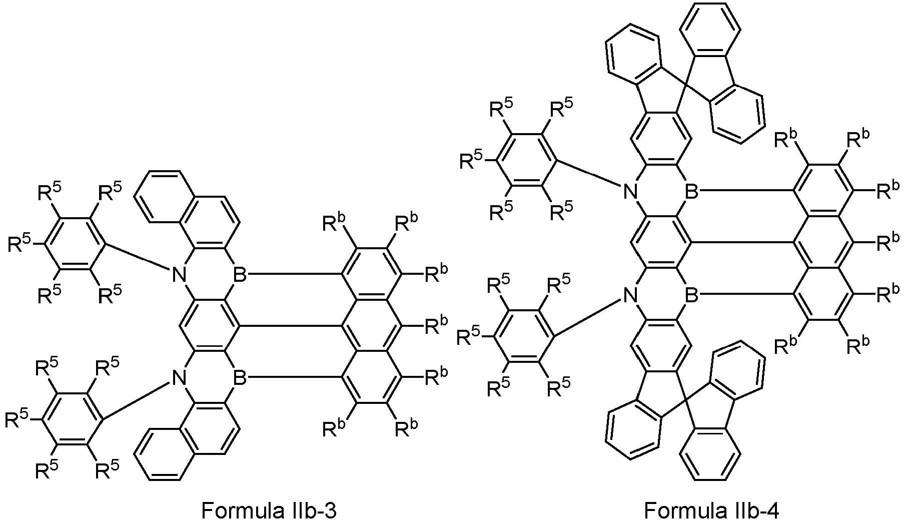 wherein, in Formula Ilb-1, Formula Ilb-2, Formula Ilb-3 and Formula Ilb-4, R^{b} and R⁵ are the same as described in connection with Formula I.

In one embodiment, the organic molecules comprise or consist of a structure of formula III: 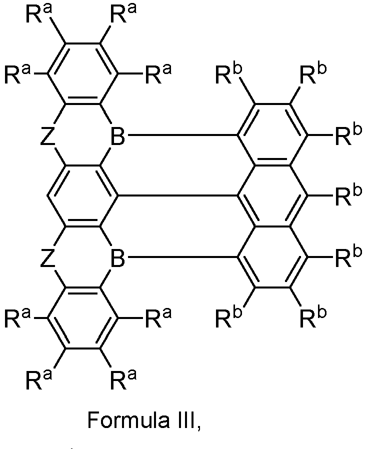 wherein, in Formula III, Z, R^{a} and R^{b} are the same as described in connection with Formula I.

In one embodiment, the organic molecules comprise or consist of a structure of formula IVa, formula IVb, formula IVc, formula IVd, formula IVe or formula IVf: 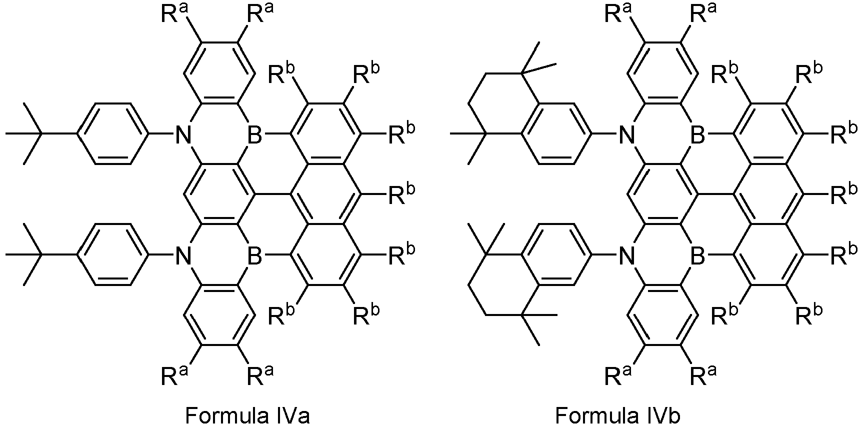 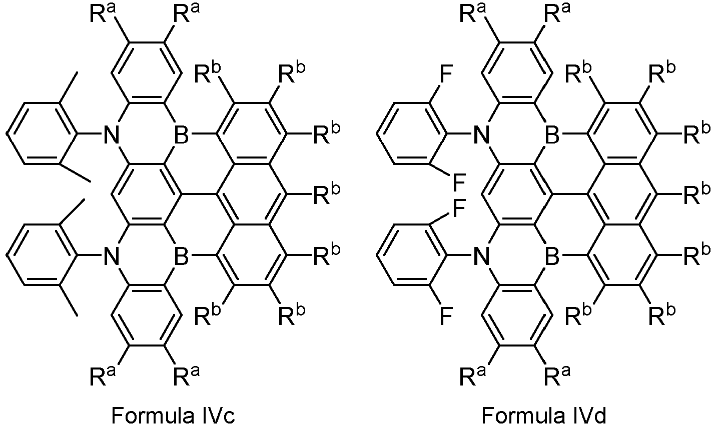 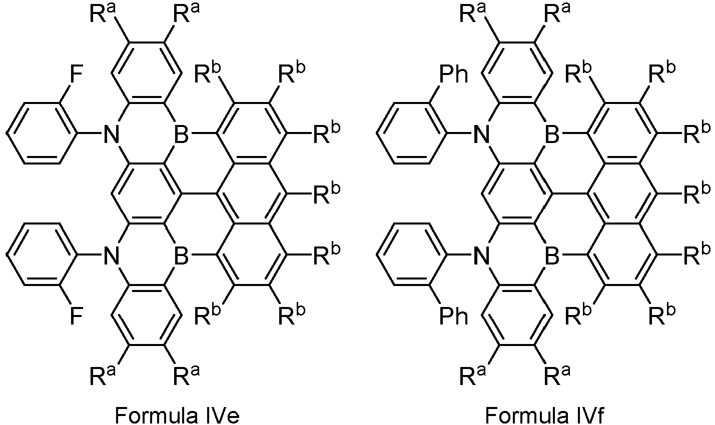 wherein, in Formula IVa, Formula IVb, Formula IVc, Formula IVd, Formula IVe and Formula IVf, R^{a} and R^{b} are the same as described in connection with Formula I.

In one embodiment, the organic molecules comprise or consist of a structure of formula V: 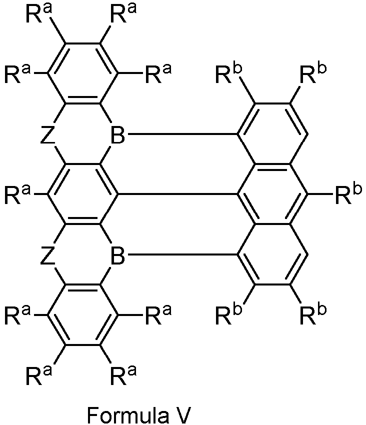 wherein, in Formula V, Z, R^{a} and R^{b} are the same as described in connection with Formula I.

In one embodiment, the organic molecules comprise or consist of a structure of formula V-1, formula V-2 or formula V-3: 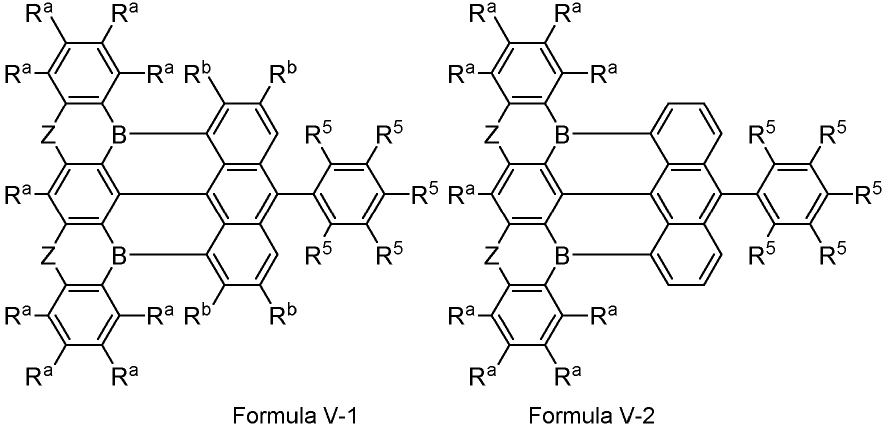 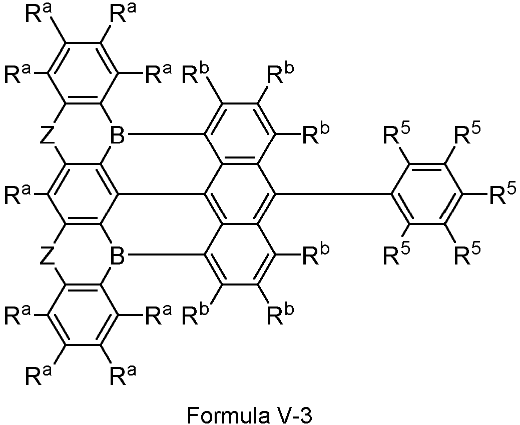 wherein, in Formula V-1, Formula V-2, and Formula V-3, Z, R^{a}, R^{b}, and R⁵ are the same as described in connection with Formula I.

In one embodiment, the organic molecules comprise or consist of a structure of formula Iva', formula IVb', formula IVc', formula IVd', formula IVe', formula IVf', formula IVg, formula IVh, formula IVi, formula IVj formula IVk: 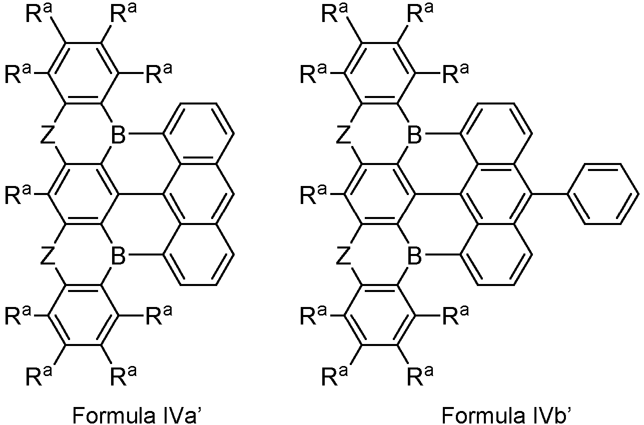 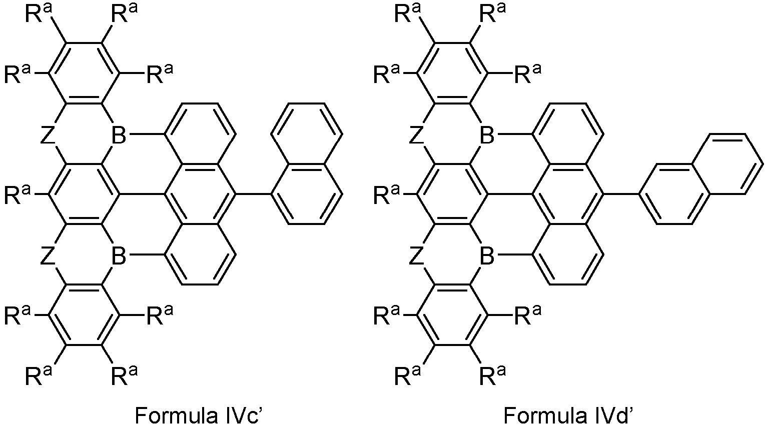 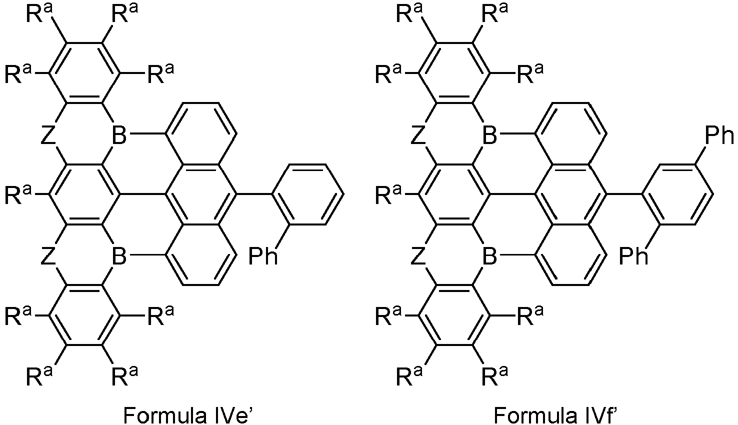 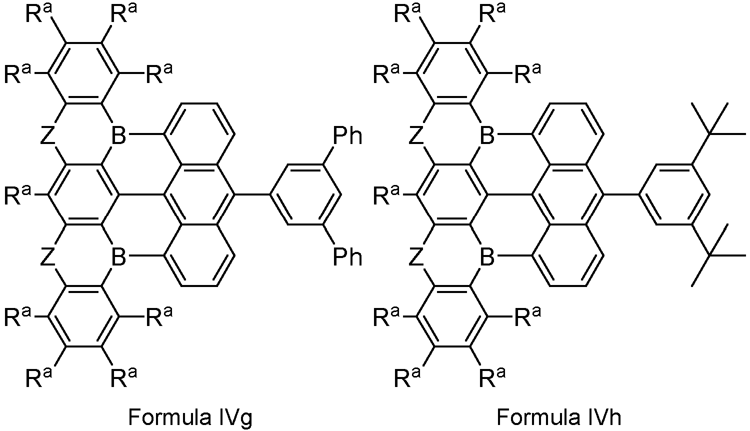 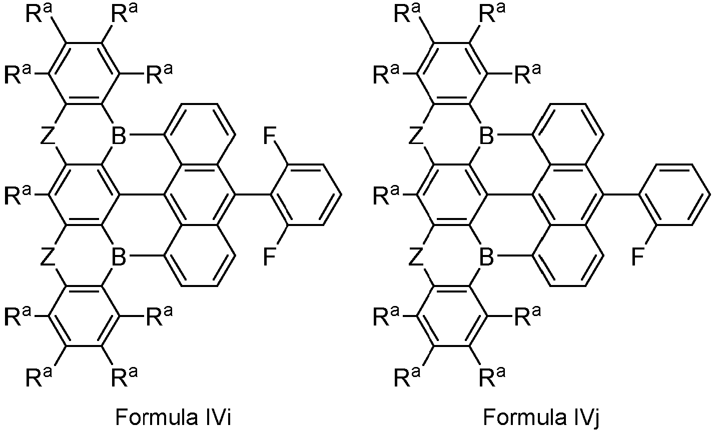 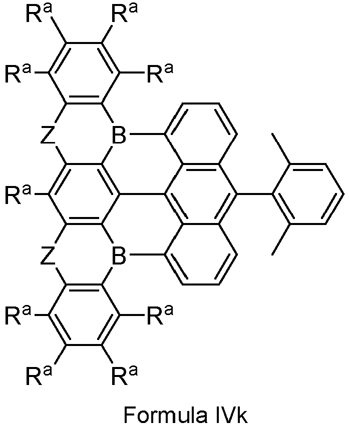 wherein, in Formula IVa', Formula IVb', Formula IVc', Formula IVd', Formula IVe', Formula IVf', Formula IVg, Formula IVh, Formula IVi, Formula IVj and Formula IVk, Z and R^{a} are the same as described in connection with Formula I.

In one embodiment, the organic molecules comprise or consist of a structure of formula V-3, wherein adjacent R^{a} substituents independently form a mono- or polycyclic, aliphatic, aromatic, heteroaromatic and/or benzo-fused ring system.

In one embodiment, the organic molecules comprise or consist of a structure of formula V-3a: 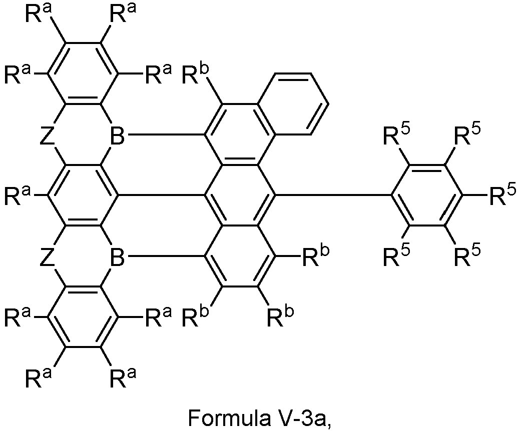 Wherein, in Formula V-3a, R^{a}, R^{b}, R⁵ and Z are the same as described in connection with Formula I.

In one embodiment of the invention, R^{b} is at each occurrence independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

The present invention also provides an oligomer for the use as an emitter in an optoelectronic device. The oligomer comprises or consists of a plurality (i.e. 2,3,4,5, or 6) of units represented by the formula VI: 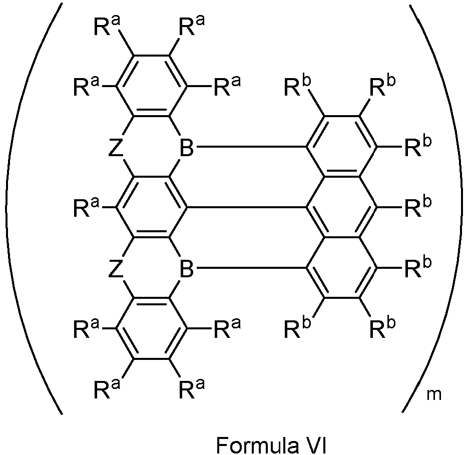 wherein, in Formula VI, Z, R^{a}, and R^{b} are the same as described in connection with Formula I.

The oligomer is a dimer to hexamer (m = 2 to 6), in particular a dimer to trimer (m = 2 or 3), or preferably a dimer (m = 2). The oligomer
- may be in a form having a plurality of the units shown as formula VIII, or
- may be in a form in which a plurality of the units shown as formula VIII are linked via a linking group selected from the group consisting of a single bond, an alkylene group having 1 to 3 carbon atoms, a phenylene group, or a naphthylene group, a anthracene group, a pyrene group, or a pyridine group, pyrimidin group or triazine group, or
- may be in a form in which a plurality of the units are linked such that ring a and/or ring b contained in the unit according to Formula VI-AB 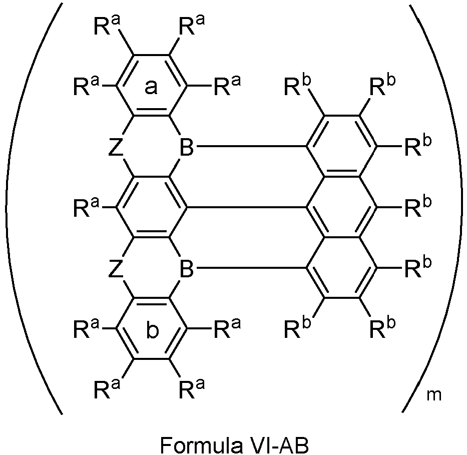 is shared by at least one other adjacent unit of the oligomer, or
- may be in a form in which units of the oligomer are linked such that ring a and/or ring b of a unit is fused with ring a and/or ring b of an adjacent unit of the oligomer;
wherein, in Formula VI-AB, R^{a}, R^{b} and Z are the same as described in connection with Formula I, and m is an integer from 2 to 6.

In one embodiment, the organic molecules comprise or consist of a structure of formula VIIIa or formula Vlllb: 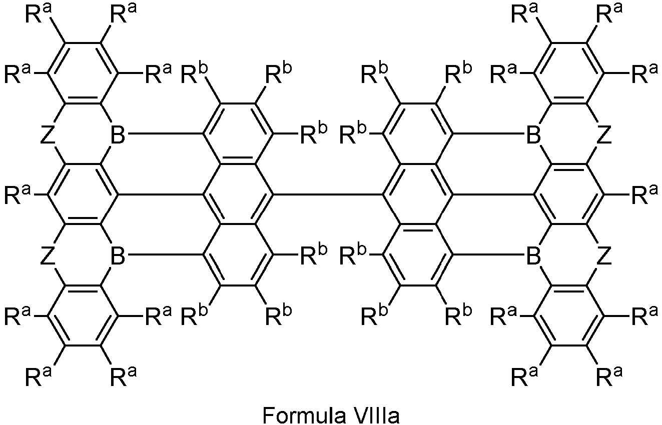 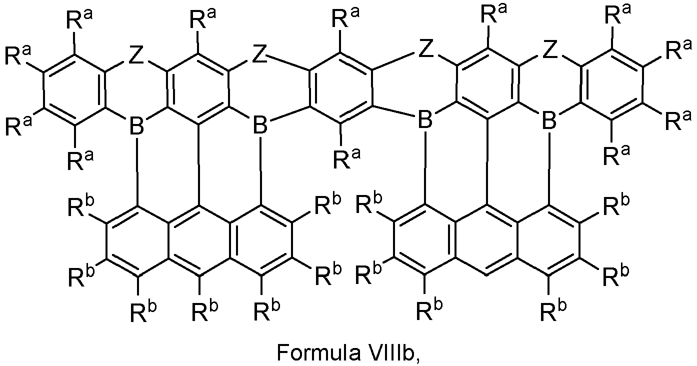 wherein, in Formula VIIIa and Formula VIIIb, R^{a}, R^{b} and Z are the same as described in connection with Formula I.

### Definitions

As used throughout the present application, the term "cyclic group" may be understood in the broadest sense as any mono-, bi- or polycyclic moieties.

As used throughout the present application, the terms "ring" and "ring system" may be understood in the broadest sense as any mono-, bi- or polycyclic moieties.

As used throughout the present application, the term "carbocycle" may be understood in the broadest sense as any cyclic group in which the cyclic core structure comprises only carbon atoms that may of course be substituted with hydrogen or any other substituents defined in the specific embodiments of the invention. It is understood that the term "carbocyclic" as adjective refers to cyclic groups in which the cyclic core structure comprises only carbon atoms that may of course be substituted with hydrogen or any other substituents defined in the specific embodiments of the invention.

As used throughout the present application, the term "heterocycle" may be understood in the broadest sense as any cyclic group in which the cyclic core structure comprises not just carbon atoms, but also at least one heteroatom. It is understood that the term "heterocyclic" as adjective refers to cyclic groups in which the cyclic core structure comprises not just carbon atoms, but also at least one heteroatom. The heteroatoms may, unless stated otherwise in specific embodiments, at each occurrence be the same or different and be individually selected from the group consisting of N, O, S, and Se. All carbon atoms or heteroatoms comprised in a heterocycle in the context of the invention may of course be substituted with hydrogen or any other substituents defined in the specific embodiments of the invention.

As used throughout the present application, the term "aromatic ring system" may be understood in the broadest sense as any bi- or polycyclic aromatic moiety.

As used throughout the present application, the term "heteroaromatic ring system" may be understood in the broadest sense as any bi- or polycyclic heteroaromatic moiety.

As used throughout the present application, the term "fused" when referring to aromatic or heteroaromatic ring systems means that the aromatic or hetroaromatic rings that are "fused" share at least one bond that is part of both ring systems. For example naphthalene (or naphthyl when referred to as substituent) or benzothiophene (or benzothiphenyl when referred to as substituent) are considered fused aromatic ring systems in the context of the present invention, in which two benzene rings (for naphthalene) or a thiophene and a benzene (for benzothiophene) share one bond. It is also understood that sharing a bond in this context includes sharing the two atoms that build up the respective bond and that fused aromatic or heteroaromatic ring systems can be understood as one aromatic or heteroaromatic system.

Additionally, it is understood, that more than one bond may be shared by the aromatic or heteroaromatic rings building up a fused aromatic or heteroaromatic ring system (e.g. in pyrene). Furthermore, it will be understood that aliphatic ring systems may also be fused and that this has the same meaning as for aromatic or heteroaromatic ring systems, with the exception of course, that fused aliphatic ring systems are not aromatic.

As used throughout the present application, the terms "aryl" and "aromatic" may be understood in the broadest sense as any mono-, bi- or polycyclic aromatic moieties. Accordingly, an aryl group contains 6 to 60 aromatic ring atoms, and a heteroaryl group contains 5 to 60 aromatic ring atoms, of which at least one is a heteroatom. Notwithstanding, throughout the application the number of aromatic ring atoms may be given as subscripted number in the definition of certain substituents. In particular, the heteroaromatic ring includes one to three heteroatoms. Again, the terms "heteroaryl" and "heteroaromatic" may be understood in the broadest sense as any mono-, bi- or polycyclic hetero-aromatic moieties that include at least one heteroatom. The heteroatoms may, unless stated otherwise in specific embodiments, at each occurrence be the same or different and be individually selected from the group consisting of N, O, S, and Se. Accordingly, the term "arylene" refers to a divalent substituent that bears two binding sites to other molecular structures and thereby serving as a linker structure. In case, a group in the exemplary embodiments is defined differently from the definitions given here, for example, the number of aromatic ring atoms or number of heteroatoms differs from the given definition, the definition in the exemplary embodiments is to be applied. According to the invention, a condensed (annulated) aromatic or heteroaromatic polycycle is built of two or more single aromatic or heteroaromatic cycles, which formed the polycycle via a condensation reaction.

In particular, as used throughout the present application the term "aryl group" or "heteroaryl group" comprises groups which can be bound via any position of the aromatic or heteroaromatic group, derived from benzene, naphthaline, anthracene, phenanthrene, pyrene, dihydropyrene, chrysene, perylene, fluoranthene, benzanthracene, benzphenanthrene, tetracene, pentacene, benzpyrene, furan, benzofuran, isobenzofuran, dibenzofuran, thiophene, benzothiophene, isobenzothiophene, dibenzothiophene, selenophene, benzoselenophene, isobenzoselenophene, dibenzoselenophene; pyrrole, indole, isoindole, carbazole, indolocarbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthoimidazole, phenanthroimidazole, pyridoimidazole, pyrazinoimidazole, quinoxalinoimidazole, oxazole, benzoxazole, napthooxazole, anthroxazol, phenanthroxazol, isoxazole, 1,2-thiazole, 1,3-thiazole, benzothiazole, pyridazine, benzopyridazine, pyrimidine, benzopyrimidine, 1,3,5-triazine, quinoxaline, pyrazine, phenazine, naphthyridine, carboline, benzocarboline, phenanthroline, 1,2,3-triazole, 1,2,4-triazole, benzotriazole, 1,2,3-oxadiazole, 1,2,4-oxadiazole, 1,2,5-oxadiazole, 1,2,3,4-tetrazine, purine, pteridine, indolizine and benzothiadiazole or combinations of the abovementioned groups.

As used throughout the present application, the term "aliphatic" when referring to ring systems may be understood in the broadest sense and means that none of the rings that build up the ring system is an aromatic or heteroaromatic ring. It is understood that such an aliphatic ring system may be fused to one or more aromatic rings so that some (but not all) carbon- or heteroatoms comprised in the core structure of the aliphatic ring system are part of an attached aromatic ring.

As used above and herein, the term "alkyl group" may be understood in the broadest sense as any linear, branched, or cyclic alkyl substituent. In particular, the term alkyl comprises the substituents methyl (Me), ethyl (Et), n-propyl ("Pr), i-propyl (ⁱPr), cyclopropyl, n-butyl ("Bu), i-butyl (ⁱBu), s-butyl (^{s}Bu), t-butyl (^{t}Bu), cyclobutyl, 2-methylbutyl, n-pentyl, s-pentyl, t-pentyl, 2-pentyl, neo-pentyl, cyclopentyl, n-hexyl, s-hexyl, t-hexyl, 2-hexyl, 3-hexyl, neo-hexyl, cyclohexyl, 1-methylcyclopentyl, 2-methylpentyl, n-heptyl, 2-heptyl, 3-heptyl, 4-heptyl, cycloheptyl, 1-methylcyclohexyl, n-octyl, 2-ethylhexyl, cyclooctyl, 1-bicyclo[2,2,2]octyl, 2-bicyclo[2,2,2]-octyl, 2-(2,6-dimethyl)octyl, 3-(3,7-dimethyl)octyl, adamantyl, 2,2,2-trifluorethyl, 1,1-dimethyl-n-hex-1-yl, 1,1-dimethyl-n-hept-1-yl, 1,1-dimethyl-n-oct-1-yl, 1,1-dimethyl-n-dec-1-yl, 1,1-dimethyl-n-dodec-1-yl, 1,1-dimethyl-n-tetradec-1-yl, 1,1-dimethyl-n-hexadec-1-yl, 1,1-dimethyl-n-octadec-1-yl, 1,1-diethyl-n-hex-1-yl, 1,1-diethyl-n-hept-1-yl, 1,1-diethyl-n-oct-1-yl, 1,1-diethyl-n-dec-1-yl, 1,1-diethyl-n-dodec-1-yl, 1,1-diethyl-n-tetradec-1-yl, 1,1-diethyln-n-hexadec-1-yl, 1,1-diethyl-n-octadec-1-yl, 1-(n-propyl)-cyclohex-1-yl, 1-(n-butyl)-cyclohex-1-yl, 1-(n-hexyl)-cyclohex-1-yl, 1-(n-octyl)-cyclohex-1-yl and 1-(n-decyl)-cyclohex-1-yl.

As used above and herein, the term "alkenyl" comprises linear, branched, and cyclic alkenyl substituents. The term alkenyl group exemplarily comprises the substituents ethenyl, propenyl, butenyl, pentenyl, cyclopentenyl, hexenyl, cyclohexenyl, heptenyl, cycloheptenyl, octenyl, cyclooctenyl or cyclooctadienyl.

As used above and herein, the term "alkynyl" comprises linear, branched, and cyclic alkynyl substituents. The term alkynyl group exemplarily comprises ethynyl, propynyl, butynyl, pentynyl, hexynyl, heptynyl or octynyl.

As used above and herein, the term "alkoxy" comprises linear, branched, and cyclic alkoxy substituents. The term alkoxy group exemplarily comprises methoxy, ethoxy, n-propoxy, i-propoxy, n-butoxy, i-butoxy, s-butoxy, t-butoxy and 2-methylbutoxy.

As used above and herein, the term "thioalkoxy" comprises linear, branched, and cyclic thioalkoxy substituents, in which the O of the exemplarily alkoxy groups is replaced by S.

As used above and herein, the terms "halogen" and "halo" may be understood in the broadest sense as being preferably fluorine, chlorine, bromine or iodine.

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

All hydrogen atoms (H) comprised in any structure referred to herein may at each occurrence independently of each other, and without this being indicated specifically, be replaced by deuterium (D). The replacement of hydrogen by deuterium is common practice and obvious for the person skilled in the art. Thus, there are numerous known methods by which this can be achieved and several review articles describing them (see for example: A. Michelotti, M. Roche, Synthesis 2019, 51(06), 1319-1328, DOI: 10.1055/s-0037-1610405; J. Atzrodt, V. Derdau, T. Fey, J. Zimmermann, Angew. Chem. Int. Ed. 2007, 46(15), 7744-7765, DOI: 10.1002/anie.200700039; Y. Sawama, Y. Monguchi, H. Sajiki, Synlett 2012, 23(7), 959-972, DOI: 10.1055/s-0031-1289696.).

It is understood that when a molecular fragment is described as being a substituent or otherwise attached to another moiety, its name may be written as if it were a fragment (e.g. naphthyl, dibenzofuryl) or as if it were the whole molecule (e.g. naphthalene, dibenzofuran). As used herein, these different ways of designating a substituent or attached fragment are considered to be equivalent.

In one embodiment of the invention, the organic molecules according to the invention have an emission peak in the visible or nearest ultraviolet range, i.e., in the range of a wavelength of from 380 nm to 800 nm, with a full width at half maximum of less than 0.35 eV, preferably less than 0.30 eV, more preferably less than 0.26 eV, even more preferably less than 0.22 eV or even less than 0.18 eV in a solution of organic solvent, in particular in dichloromethane (DCM), toluene or chloroform, of organic molecule or in a film of poly(methyl methacrylate) (PMMA) with 1-5 % by weight, in particular with 2% by weight of organic molecule at room temperature.

The energy of the first excited triplet state T1 is determined from the onset of the emission spectrum at low temperature, typically at 77 K. The phosphorescence is usually visible in a steady-state spectrum in a film of 2% emitter and 98% PMMA or in organic solvent, in particular in DCM, toluene or chloroform. The triplet energy can thus be determined as the onset of the phosphorescence spectrum. For fluorescent emitter molecules, the energy of the first excited triplet state T1 is determined from the onset of the delayed emission spectrum at 77 K.

The photoluminescence quantum yields of the organic molecules according to the invention are, in particular, 30 % or more, preferably more than 50%, more preferably more than 70%, even more preferably more than 80% or even more than 90% in a solution of organic solvent, in particular in dichloromethane (DCM), toluene or chloroform, of 0.001 mg/mL of organic molecule according to the invention at room temperature.

The onset of an emission spectrum is determined by computing the intersection of the tangent to the emission spectrum with the x-axis. The tangent to the emission spectrum is set at the high-energy side of the emission band and at the point at half maximum of the maximum intensity of the emission spectrum.

In one embodiment, the organic molecules according to the invention have an onset of the emission spectrum, which is energetically close to the emission maximum, i.e. the energy difference between the onset of the emission spectrum and the energy of the emission maximum is below 0.14 eV, preferably below 0.13 eV, or even below 0.12 eV, while the full width at half maximum (FWHM) of the organic molecules is less than 0.35 eV, preferably less than 0.30 eV, more preferably less than 0.26 eV, even more preferably less than 0.22 eV or even less than 0.18 eV with 0.001 mg/mL of organic molecule according to the invention in toluene or DCM at room temperature.

### Further aspects and embodiments of the invention

A further aspect of the invention relates to the use of an organic molecule of the invention as a luminescent emitter or as an absorber, and/or as a host material and/or as an electron transport material, and/or as a hole injection material, and/or as a hole blocking material in an optoelectronic device.

A preferred embodiment relates to the use of an organic molecule according to the invention as a luminescent emitter in an optoelectronic device.

The optoelectronic device may be understood in the broadest sense as any device based on organic materials that is suitable for emitting light in the visible or nearest ultraviolet (UV) range, i.e. in the range of a wavelength of from 380 to 800 nm. More preferably, the optoelectronic device may be able to emit light in the visible range, i.e. light of from 400 nm to 800 nm.

In the context of such use, the optoelectronic device is more particularly selected from the group consisting of:
organic light-emitting diodes (OLEDs),
light-emitting electrochemical cells,
OLED sensors, especially in gas and vapor sensors that are not hermetically shielded to the surroundings,
organic diodes,
organic solar cells,
organic transistors,
organic field-effect transistors,
organic lasers, and
down-conversion elements.

In a preferred embodiment in the context of such use, the optoelectronic device is a device selected from the group consisting of an organic light emitting diode (OLED), a light emitting electrochemical cell (LEC), and a light-emitting transistor.

In the case of the use, the fraction of the organic molecule according to the invention in the emission layer in an optoelectronic device, more particularly in an OLED, is 0.1 % to 99 % by weight, more particularly 1 % to 80 % by weight. In an alternative embodiment, the proportion of the organic molecule in the emission layer is 100 % by weight.

In one embodiment, the light-emitting layer comprises not only the organic molecules according to the invention, but also a host material whose triplet (T1) and singlet (S1) energy levels are energetically higher than the triplet (T1) and singlet (S1) energy levels of the organic molecule.

### Host material(s) H^{B}

According to the invention, any of the one or more host materials H^{B} comprised in any of the at least one light-emitting layers B may be a p-host H^{P} exhibiting high hole mobility, an n-host H^{N} exhibiting high electron mobility, or a bipolar host material H^{BP} exhibiting both, high hole mobility and high electron mobility.

According to the invention, a p-host H^{P} optionally comprised in any of the at least one light-emitting layers B of an optoelectronic device according to the invention has a highest occupied molecular orbital HOMO(H^{P}) having an energy E^{HOMO}(H^{P}), wherein preferably: -6.1 eV ≤ E^{HOMO}(H^{P}) ≤ -5.6 eV.

According to the invention, a p-host H^{P} optionally comprised in any of the at least one light-emitting layers B of an optoelectronic device according to the invention has a lowest unoccupied molecular orbital LUMO(H^{P}) having an energy E^{LUMO}(H^{P}), wherein preferably: -2.6 eV ≤ E^{LUMO}(H^{P}).

According to the invention, a p-host H^{P} optionally comprised in any of the at least one light-emitting layers B of an optoelectronic device according to the invention has a lowermost excited singlet state energy level E(S1^{p-H}), wherein preferably: E(S1^{p-H}) ≥ 3.0 eV.

According to the invention, a p-host H^{P} optionally comprised in any of the at least one light-emitting layers B of an optoelectronic device according to the invention has a lowermost excited triplet state energy level E(T1 ^{p-H}), wherein preferably: E(T1^{p-H}) ≥ 2.7 eV.

It is understood that any requirements or preferred features previously defined for a host material H^{B} comprised in any of the at least one light-emitting layers B of an optoelectronic device according to the invention are preferably also valid for a p-host H^{P} according to the invention. Thus, in a preferred embodiment, the relations expressed by the following formulas (6) to (9) apply: $E \left(S{1}^{p - H}\right) > E \left(S{1}^{E}\right)$ (6) $E \left(S{1}^{p - H}\right) > E \left(S{1}^{S}\right)$ (7) $E \left(T{1}^{p - H}\right) > E \left(T{1}^{S}\right)$ (8) $E \left(T{1}^{p - H}\right) > E \left(T{1}^{E}\right)$ (9).

Accordingly, the lowermost excited singlet state S1^{p-H} of a p-host H^{P} is preferably higher in energy than the lowermost excited singlet state S1^{E} of a TADF material E^{B}. The lowermost excited singlet state S1^{p-H} of a p-host H^{P} is preferably higher in energy than the lowermost excited singlet state S1^{S} of any small FWHM emitter S^{B}. The lowermost excited triplet state T1^{p-H} of a p-host H^{P} is preferably higher in energy than the lowermost excited triplet state T1^{S} of any small FWHM emitter S^{B}. The lowermost excited triplet state T1^{p-H} of a p-host H^{P} is preferably higher in energy than the lowermost excited triplet state T1^{E} of a TADF material E^{B}.

According to the invention, an n-host H^{N} optionally comprised in any of the at least one light-emitting layers B of an optoelectronic device according to the invention has a highest occupied molecular orbital HOMO(H^{N}) having an energy E^{HOMO}(H^{N}), wherein preferably: E^{HOMO}(H^{N}) ≤ _ 5.9 eV.

According to the invention, an n-host H^{N} optionally comprised in any of the at least one light-emitting layers B of an optoelectronic device according to the invention has a lowest unoccupied molecular orbital LUMO(H^{N}) having an energy E^{LUMO}(H^{N}), wherein preferably: -3.5 eV ≤ E^{LUMO}(H^{N}) ≤ -2.9 eV.

According to the invention, an n-host H^{N} optionally comprised in any of the at least one light-emitting layers B of an optoelectronic device according to the invention has a lowermost excited singlet state energy level E(S1^{n-H}), wherein preferably: E(S1^{n-H}) ≥ 3.0 eV.

According to the invention, an n-host H^{N} optionally comprised in any of the at least one light-emitting layers B of an optoelectronic device according to the invention has a lowermost excited triplet state energy level E(T1^{n-H}), wherein preferably: E(T1^{n-H}) ≥ 2.7 eV.

It is understood that any requirements or preferred properties previously defined for a host material H^{B} comprised in any of the at least one light-emitting layers B of an optoelectronic device according to the invention are preferably also valid for an n-host H^{N} according to the invention. Thus, in a preferred embodiment, the relations expressed by the following formulas (10) to (13) apply: $E \left(S{1}^{n - H}\right) > E \left(S{1}^{E}\right)$ (10) $E \left(S{1}^{n - H}\right) > E \left(S{1}^{S}\right)$ (11) $E \left(T{1}^{n - H}\right) > E \left(T{1}^{S}\right)$ (12) $E \left(T{1}^{n - H}\right) > E \left(T{1}^{E}\right)$ (13).

Accordingly, the lowermost excited singlet state S1^{n-H} of an n-host H^{N} is preferably higher in energy than the lowermost excited singlet state S1^{E} of a TADF material E^{B}. The lowermost excited singlet state S1^{n-H} of an n-host H^{N} is preferably higher in energy than the lowermost excited singlet state S1^{S} of any small FWHM emitter S^{B}. The lowermost excited triplet state T1^{n-H} of an n-host H^{N} is preferably higher in energy than the lowermost excited triplet state T1^{S} of any small FWHM emitter S^{B}. Preferably, the lowermost excited triplet state T1^{n-H} of any n-host H^{N} is higher in energy than the lowermost excited triplet state T1^{E} of any TADF material E^{B}.

According to the invention, a bipolar host H^{BP} optionally comprised in any of the at least one light-emitting layers B of an optoelectronic device according to the invention has a lowest unoccupied molecular orbital LUMO(H^{BP}) having an energy E^{LUMO}(H^{BP}), wherein preferably: - 3.5 eV ≤ E^{LUMO}(H^{BP}) ≤ -2.9 eV.

According to the invention, a bipolar host H^{BP} optionally comprised in any of the at least one light-emitting layers B of an optoelectronic device according to the invention has a lowermost excited singlet state energy level E(S1^{bp-H}), wherein preferably: E(S1^{bp-H}) ≥ 3.0 eV.

According to the invention, a bipolar host H^{BP} optionally comprised in any of the at least one light-emitting layers B of an optoelectronic device according to the invention has a lowermost excited triplet state energy level E(T1 ^{bp-H}), wherein preferably: E(T1 ^{bp-H}) ≥ 2.7 eV.

It is understood that any requirements or preferred properties previously defined for a host material H^{B} comprised in any of the at least one light-emitting layers B of an optoelectronic device according to the invention are preferably also valid for a bipolar host H^{BP} according to the invention. Thus, in a preferred embodiment, the relations expressed by the following formulas (14) to (17) apply: $E \left(S{1}^{bp - H}\right) > E \left(S{1}^{E}\right)$ (14) $E \left(S{1}^{bp - H}\right) > E \left(S{1}^{S}\right)$ (15) $E \left(T{1}^{bp - H}\right) > E \left(T{1}^{S}\right)$ (16) $E \left(T{1}^{bp - H}\right) > E \left(T{1}^{E}\right)$ (17).

Accordingly, the lowermost excited singlet state S1^{bp-H} of a bipolar host H^{BP} is preferably higher in energy than the lowermost excited singlet state S1^{E} of a TADF material E^{B}. The lowermost excited singlet state S1^{bp-H} of a bipolar host H^{BP} is preferably higher in energy than the lowermost excited singlet state S1^{S} of any small FWHM emitter S^{B}. The lowermost excited triplet state T1^{bp-H} of a bipolar host H^{BP} is preferably higher in energy than the lowermost excited triplet state T1^{S} of any small FWHM emitter S^{B}. Preferably, the lowermost excited triplet state T1^{bp-H} of any bipolar host H^{BP} is higher in energy than the lowermost excited triplet state T1^{E} of any TADF material E^{B}.

### TADF material(s) E^{B}

According to the invention, any of the one or more thermally activated delayed fluorescence (TADF) materials E^{B} is preferably characterized by exhibiting a ΔE_{ST} value, which corresponds to the energy difference between the lowermost excited singlet state S1^{E} and the lowermost excited triplet state T1^{E}, of less than 0.4 eV, preferably of less than 0.3 eV, more preferably of less than 0.2 eV, even more preferably of less than 0.1 eV, or even of less than 0.05 eV. Thus, ΔE_{ST} of a TADF material E^{B} according to the invention is preferably sufficiently small to allow for thermal repopulation of the lowermost excited singlet state S1^{E} to the lowermost excited triplet state T1^{E} (also referred to as up-intersystem crossing or reverse intersystem crossing) at room temperature (RT).

It is understood that a small FWHM emitter S^{B} comprised in the at least one light-emitting layer B of an optoelectronic device according to the invention may optionally also have a ΔE_{ST} value of less than 0.4 eV and exhibit thermally activated delayed fluorescence (TADF). However, for any small FWHM emitter S^{B} in the context of the invention, this is only an optional feature. Additionally, a TADF material E^{B} in the context of the invention preferably differs from a small FWHM emitter S^{B} in the context of the invention in that a TADF material E^{B} mainly functions as energy pump transferring energy to at least one small FWHM emitter S^{B} while the main contribution to the emission band of the optoelectronic device according to the invention can preferably be attributed to the emission of at least one small FWHM emitter S^{B}.

According to the invention, a TADF material E^{B} comprised in any of the at least one light-emitting layers B of an optoelectronic device according to the invention has a highest occupied molecular orbital HOMO(E^{B}) having an energy E^{HOMO}(E^{B}), wherein preferably: -6.0 eV ≤ E^{HOMO}(E^{B}) ≤ -5.8 eV.

According to the invention, a TADF material E^{B} comprised in any of the at least one light-emitting layers B of an optoelectronic device according to the invention has a lowest unoccupied molecular orbital LUMO(E^{B}) having an energy E^{LUMO}(E^{B}), wherein preferably: -3.4 eV ≤ E^{LUMO}(E^{B}) ≤ -3.0 eV.

According to the invention, a TADF material E^{B} comprised in any of the at least one light-emitting layers B of an optoelectronic device according to the invention has a lowermost excited singlet state energy level E(S1^{E}), wherein preferably: 2.5 eV ≤ E(S1^{E}) ≤ 2.8 eV.

According to the invention, a TADF material E^{B} comprised in any of the at least one light-emitting layers B of an optoelectronic device according to the invention has a lowermost excited triplet state energy level E(T1^{E}), whose preferred range may be defined by the above-mentioned preferred range for the singlet state energy level E(S1^{E}) in combination with the above-mentioned preferred range for ΔE_{ST}.

A further aspect of the invention relates to a composition comprising or consisting of:
(a) at least one organic molecule according to the invention, in particular in the form of an emitter, and
(b) one or more triplet-triplet annihilation (TTA) host materials, which differ from the organic molecule according to the invention and
(c) optionally one or more TADF materials
(d) optionally one or more dyes and/or one or more solvents.

A further aspect of the invention relates to a composition comprising or consisting of:
(a) at least one organic molecule according to the invention, in particular in the form of an emitter, and
(b) one or more host materials, which differ from the organic molecule according to the invention and
(c) one or more TADF materials.

A further aspect of the invention relates to a composition comprising or consisting of:
(a) at least one organic molecule according to the invention, in particular in the form of an emitter, and
(b) one or more host materials, which differ from the organic molecule according to the invention and
(c) one or more phosphorescent materials.

In a particular embodiment, the light-emitting layer EML comprises (or essentially consists of) a composition comprising or consisting of:
(i) 0.1-10 % by weight, preferably 0.5-5 % by weight, in particular 1-3 % by weight, of one or more organic molecules according to the invention;
(ii) 5-99 % by weight, preferably 15-85 % by weight, in particular 20-75% by weight, of at least one host compound H; and
(iii) 0.9-94.9 % by weight, preferably 14.5-80 % by weight, in particular 24-77 % by weight, of at least one further host compound D with a structure differing from the structure of the molecules according to the invention; and
(iv) optionally 0-94 % by weight, preferably 0-65 % by weight, in particular 0-50 % by weight, of a solvent; and
(v) optionally 0-30 % by weight, in particular 0-20 % by weight, preferably 0-5 % by weight, of at least one further emitter molecule F with a structure differing from the structure of the molecules according to the invention.

### Compositions with one or more TTA host material

In a preferred embodiment, in the optoelectronic device of the present invention, the light-emitting layer B comprises (or consist of):
(i) 10-84 % by weight of the TTA material;
(ii) 0-30 % by weight of the TADF material E^{B}; and
(iii) 0.1-10 % by weight of the emitter according to the invention; and optionally
(iv) 0-89.9 % by weight of one or more solvents.

In a preferred embodiment, the percentage numbers of (i)-(iv) sum up to 100 % by weight.

In another preferred embodiment, in the optoelectronic device of the present invention, the light-emitting layer B comprises (or consist of):
(i) 56-90 % by weight of the TTA material;
(ii) 0-5 % by weight of the TADF material E^{B}; and
(iii) 0.5-5 % by weight of the emitter according to the invention; and optionally
(iv) 0-43.5 % by weight of one or more solvents.

In a preferred embodiment, the percentage numbers of (i)-(iv) sum up to 100 % by weight.

### Compositions with one or more TADF material

In one embodiment, the light-emitting layer B comprises:
(i) 10-89.9 % by weight of one or more p-host compound H^{P};
(ii) 0-79.9 % by weight of one or more n-host compound H^{N};
(iii) 10-50 % by weight of one or more TADF material E^{B}; and
(iv) 0.1-10 % by weight of one or more emitter according to the invention; and
(v) 0-89.9 % by weight of one or more solvents.

In one embodiment, the light-emitting layer B comprises:
(i) 22-87.5 % by weight of one or more p-host compound H^{P};
(ii) optionally 0-65.5 % by weight of one or more n-host compound H^{N};
(iii) 12-40 % by weight of one or more TADF material E^{B}; and
(iv) 0.5-5 % by weight of one or more emitter according to the invention; and
(v) 0-65.5 % by weight of one or more solvents.

### Compositions with one or more phosphorescent material

In a preferred embodiment where H^{N} is optional, in the optoelectronic device of the present invention, the light-emitting layer B comprises (or consists of):
(i) 10-84.9 % by weight of the host compound H^{P};
(ii) 0-84.9 % by weight of the host compound H^{N};
(iii) 5-15 % by weight of the Phosphorescence material E^{B}; and
(iv) 0.1-10 % by weight of the emitter according to the invention; and optionally
(v) 0-84.9 % by weight of one or more solvents.

In a preferred embodiment where H^{N} is optional, in the optoelectronic device of the present invention, the light-emitting layer B comprises (or consists of):
(i) 22-70.5 % by weight of the host compound H^{P};
(ii) 0-70.5 % by weight of the host compound H^{N};
(iii) 5-10 % by weight of the phosphorescence material E^{B}; and
(iv) 0.5-5 % by weight of the emitter according to the invention; and optionally
(v) 0-72.5 % by weight of one or more solvents.

Preferably, energy can be transferred from the host compound H to the one or more organic molecules according to the invention, in particular transferred from the first excited triplet state T1(H) of the host compound H to the first excited triplet state T1(E) of the one or more organic molecules according to the invention E and/or from the first excited singlet state S1(H) of the host compound H to the first excited singlet state S1(E) of the one or more organic molecules according to the invention E.

In one embodiment, the host compound H has a highest occupied molecular orbital HOMO(H) having an energy E^{HOMO}(H) in the range of from -5 to -6.5 eV and the at least one further host compound D has a highest occupied molecular orbital HOMO(D) having an energy E^{HOMO}(D), wherein E^{HOMO}(H) > E^{HOMO}(D).

In a further embodiment, the host compound H has a lowest unoccupied molecular orbital LUMO(H) having an energy E^{LUMO}(H) and the at least one further host compound D has a lowest unoccupied molecular orbital LUMO(D) having an energy E^{LUMO}(D), wherein E^{LUMO}(H) > E^{LUMO}(D).

In one embodiment, the host compound H has a highest occupied molecular orbital HOMO(H) having an energy E^{HOMO}(H) and a lowest unoccupied molecular orbital LUMO(H) having an energy E^{LUMO}(H), and
the at least one further host compound D has a highest occupied molecular orbital HOMO(D) having an energy E^{HOMO}(D) and a lowest unoccupied molecular orbital LUMO(D) having an energy E^{LUMO}(D),
the organic molecule according to the invention E has a highest occupied molecular orbital HOMO(E) having an energy E^{HOMO}(E) and a lowest unoccupied molecular orbital LUMO(E) having an energy E^{LUMO}(E),
wherein
E^{HOMO}(H) > E^{HOMO}(D) and the difference between the energy level of the highest occupied molecular orbital HOMO(E) of the organic molecule according to the invention E (E^{HOMO}(E)) and the energy level of the highest occupied molecular orbital HOMO(H) of the host compound H (E^{HOMO}(H)) is between -0.5 eV and 0.5 eV, more preferably between -0.3 eV and 0.3 eV, even more preferably between -0.2 eV and 0.2 eV or even between -0.1 eV and 0.1 eV; and
E^{LUMO}(H) > E^{LUMO}(D) and the difference between the energy level of the lowest unoccupied molecular orbital LUMO(E) of the organic molecule according to the invention E (E^{LUMO}(E)) and
the lowest unoccupied molecular orbital LUMO(D) of the at least one further host compound D (E^{LUMO}(D)) is between -0.5 eV and 0.5 eV, more preferably between -0.3 eV and 0.3 eV, even more preferably between -0.2 eV and 0.2 eV or even between -0.1 eV and 0.1 eV.

In one embodiment of the invention the host compound D and/or the host compound H is a thermally-activated delayed fluorescence (TADF)-material. TADF materials exhibit a ΔE_{ST} value, which corresponds to the energy difference between the first excited singlet state (S1) and the first excited triplet state (T1), of less than 2500 cm⁻¹. Preferably the TADF material exhibits a ΔE_{ST} value of less than 3000 cm⁻¹, more preferably less than 1500 cm⁻¹, even more preferably less than 1000 cm⁻¹ or even less than 500 cm⁻¹.

In one embodiment, the host compound D is a TADF material and the host compound H exhibits a ΔE_{ST} value of more than 2500 cm⁻¹. In a particular embodiment, the host compound D is a TADF material and the host compound H is selected from group consisting of CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole.

In one embodiment, the host compound H is a TADF material and the host compound D exhibits a ΔE_{ST} value of more than 2500 cm⁻¹. In a particular embodiment, the host compound H is a TADF material and the host compound D is selected from group consisting of T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine).

In a further aspect, the invention relates to an optoelectronic device comprising an organic molecule or a composition of the type described here, more particularly in the form of a device selected from the group consisting of organic light-emitting diode (OLED), light-emitting electrochemical cell, OLED sensor (particularly gas and vapor sensors not hermetically externally shielded), organic diode, organic solar cell, organic transistor, organic field-effect transistor, organic laser and down-conversion element.

In a preferred embodiment, the optoelectronic device is a device selected from the group consisting of an organic light emitting diode (OLED), a light emitting electrochemical cell (LEC), and a light-emitting transistor.

In one embodiment of the optoelectronic device of the invention, the organic molecule according to the invention E is used as emission material in a light-emitting layer EML.

In one embodiment of the optoelectronic device of the invention, the light-emitting layer EML consists of the composition according to the invention described here.

When the optoelectronic device is an OLED, it may, for example, have the following layer structure:
1. substrate
2. anode layer A
3. hole injection layer, HIL
4. hole transport layer, HTL
5. electron blocking layer, EBL
6. emitting layer, EML
7. hole blocking layer, HBL
8. electron transport layer, ETL
9. electron injection layer, EIL
10. cathode layer,
wherein the OLED comprises each layer selected from the group of HIL, HTL, EBL, HBL, ETL, and EIL only optionally, different layers may be merged and the OLED may comprise more than one layer of each layer type defined above.

Furthermore, the optoelectronic device may, in one embodiment, comprise one or more protective layers protecting the device from damaging exposure to harmful species in the environment including, for example, moisture, vapor and/or gases.

In one embodiment of the invention, the optoelectronic device is an OLED, with the following inverted layer structure:
1. substrate
2. cathode layer
3. electron injection layer, EIL
4. electron transport layer, ETL
5. hole blocking layer, HBL
6. emitting layer, B
7. electron blocking layer, EBL
8. hole transport layer, HTL
9. hole injection layer, HIL
10. anode layer A
wherein the OLED comprises each layer selected from the group of HIL, HTL, EBL, HBL, ETL, and EIL only optionally, different layers may be merged and the OLED may comprise more than one layer of each layer types defined above.

In one embodiment of the invention, the optoelectronic device is an OLED, which may have a stacked architecture. In this architecture, contrary to the typical arrangement in which the OLEDs are placed side by side, the individual units are stacked on top of each other. Blended light may be generated with OLEDs exhibiting a stacked architecture, in particular white light may be generated by stacking blue, green and red OLEDs. Furthermore, the OLED exhibiting a stacked architecture may comprise a charge generation layer (CGL), which is typically located between two OLED subunits and typically consists of a n-doped and p-doped layer with the n-doped layer of one CGL being typically located closer to the anode layer.

In one embodiment of the invention, the optoelectronic device is an OLED, which comprises two or more emission layers between anode and cathode. In particular, this so-called tandem OLED comprises three emission layers, wherein one emission layer emits red light, one emission layer emits green light and one emission layer emits blue light, and optionally may comprise further layers such as charge generation layers, blocking or transporting layers between the individual emission layers. In a further embodiment, the emission layers are adjacently stacked. In a further embodiment, the tandem OLED comprises a charge generation layer between each two emission layers. In addition, adjacent emission layers or emission layers separated by a charge generation layer may be merged.

The substrate may be formed by any material or composition of materials. Most frequently, glass slides are used as substrates. Alternatively, thin metal layers (e.g., copper, gold, silver or aluminum films) or plastic films or slides may be used. This may allow for a higher degree of flexibility. The anode layer A is mostly composed of materials allowing to obtain an (essentially) transparent film. As at least one of both electrodes should be (essentially) transparent in order to allow light emission from the OLED, either the anode layer A or the cathode layer C is transparent. Preferably, the anode layer A comprises a large content or even consists of transparent conductive oxides (TCOs). Such anode layer A may, for example, comprise indium tin oxide, aluminum zinc oxide, fluorine doped tin oxide, indium zinc oxide, PbO, SnO, zirconium oxide, molybdenum oxide, vanadium oxide, tungsten oxide, graphite, doped Si, doped Ge, doped GaAs, doped polyaniline, doped polypyrrol and/or doped polythiophene.

The anode layer A (essentially) may consist of indium tin oxide (ITO) (e.g., (InO₃)_{0.9}(SnO₂)_{0.1}). The roughness of the anode layer A caused by the transparent conductive oxides (TCOs) may be compensated by using a hole injection layer (HIL). Further, the HIL may facilitate the injection of quasi charge carriers (i.e., holes) in that the transport of the quasi charge carriers from the TCO to the hole transport layer (HTL) is facilitated. The hole injection layer (HIL) may comprise poly-3,4-ethylendioxy thiophene (PEDOT), polystyrene sulfonate (PSS), MoO₂, V₂O₅, CuPC or Cul, in particular a mixture of PEDOT and PSS. The hole injection layer (HIL) may also prevent the diffusion of metals from the anode layer A into the hole transport layer (HTL). The HIL may, for example, comprise PEDOT:PSS (poly-3,4-ethylendioxy thiophene: polystyrene sulfonate), PEDOT (poly-3,4-ethylendioxy thiophene), mMTDATA (4,4',4"-tris[phenyl(m-tolyl)amino]triphenylamine), Spiro-TAD (2,2',7,7'-tetrakis(n,n-diphenylamino)-9,9'-spirobifluorene), DNTPD (N1,N1'-(biphenyl-4,4'-diyl)bis(N1-phenyl-N4,N4-di-m-tolylbenzene-1,4-diamine), NPB (N,N'-nis-(1-naphthalenyl)-N,N'-bis-phenyl-(1,1'-biphenyl)-4,4'-diamine), NPNPB (N,N'-diphenyl-N,N'-di-[4-(N,N-diphenyl-amino)phenyl]benzidine), MeO-TPD (N,N,N',N'-tetrakis(4-methoxyphenyl)benzidine), HAT-CN (1,4,5,8,9,11-hexaazatriphenylen-hexacarbonitrile) and/or Spiro-NPD (N,N'-diphenyl-N,N'-bis-(1-naphthyl)-9,9'-spirobifluorene-2,7-diamine).

Adjacent to the anode layer A or hole injection layer (HIL), a hole transport layer (HTL) is typically located. Herein, any hole transport compound may be used. For example, electron-rich heteroaromatic compounds such as triarylamines and/or carbazoles may be used as hole transport compound. The HTL may decrease the energy barrier between the anode layer A and the light-emitting layer EML. The hole transport layer (HTL) may also be an electron blocking layer (EBL). Preferably, hole transport compounds bear comparably high energy levels of their triplet states T1. For example, the hole transport layer (HTL) may comprise a star-shaped heterocycle such as tris(4-carbazoyl-9-ylphenyl)amine (TCTA), poly-TPD (poly(4-butylphenyl-diphenyl-amine)), [alpha]-NPD (poly(4-butylphenyl-diphenyl-amine)), TAPC (4,4'-cyclohexyliden-bis[N,N-bis(4-methylphenyl)benzenamine]), 2-TNATA (4,4',4"-tris[2-naphthyl(phenyl)amino]triphenylamine), Spiro-TAD, DNTPD, NPB, NPNPB, MeO-TPD, HAT-CN and/or TrisPcz (9,9'-diphenyl-6-(9-phenyl-9H-carbazol-3-yl)-9H,9'H-3,3'-bicarbazole). In addition, the HTL may comprise a p-doped layer, which may be composed of an inorganic or organic dopant in an organic hole-transporting matrix. Transition metal oxides such as vanadium oxide, molybdenum oxide or tungsten oxide may, for example, be used as inorganic dopant. Tetrafluorotetracyanoquinodimethane (F₄-TCNQ), copper-pentafluorobenzoate (Cu(I)pFBz) or transition metal complexes may, for example, be used as organic dopant.

The EBL may, for example, comprise mCP (1,3-bis(carbazol-9-yl)benzene), TCTA, 2-TNATA, mCBP (3,3-di(9H-carbazol-9-yl)biphenyl), tris-Pcz, CzSi (9-(4-tert-Butylphenyl)-3,6-bis(triphenylsilyl)-9H-carbazole), and/or DCB (N,N'-dicarbazolyl-1,4-dimethylbenzene).

Adjacent to the hole transport layer (HTL), the light-emitting layer EML is typically located. The light-emitting layer EML comprises at least one light emitting molecule. Particularly, the EML comprises at least one light emitting molecule according to the invention E. In one embodiment, the light-emitting layer comprises only the organic molecules according to the invention. Typically, the EML additionally comprises one or more host materials H. For example, the host material H is selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenyl] ether oxide), 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole, 9-[3,5-bis(2-dibenzothiophenyl)phenyl]-9H-carbazole, T2T (2,4,6-tris(biphenyl-3-yl)-1,3,5-triazine), T3T (2,4,6-tris(triphenyl-3-yl)-1,3,5-triazine) and/or TST (2,4,6-tris(9,9'-spirobifluorene-2-yl)-1,3,5-triazine). The host material H typically should be selected to exhibit first triplet (T1) and first singlet (S1) energy levels, which are energetically higher than the first triplet (T1) and first singlet (S1) energy levels of the organic molecule.

In one embodiment of the invention, the EML comprises a so-called mixed-host system with at least one hole-dominant host and one electron-dominant host. In a particular embodiment, the EML comprises exactly one light emitting organic molecule according to the invention and a mixed-host system comprising T2T as electron-dominant host and a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole as hole-dominant host. In a further embodiment the EML comprises 50-80 % by weight, preferably 60-75 % by weight of a host selected from CBP, mCP, mCBP, 9-[3-(dibenzofuran-2-yl)phenyl]-9H-carbazole, 9-[3-(dibenzofuran-2-yl)phenyl]-9H-carbazole, 9-[3-(dibenzothiophen-2-yl)phenyl]-9H-carbazole, 9-[3,5-bis(2-dibenzofuranyl)phenyl]-9H-carbazole and 9-[3,5-bis(2-dibenzothiophenyl)phenyl]-9H-carbazole; 10-45 % by weight, preferably 15-30 % by weight of T2T and 5-40 % by weight, preferably 10-30 % by weight of light emitting molecule according to the invention.

Adjacent to the light-emitting layer EML, an electron transport layer (ETL) may be located. Herein, any electron transporter may be used. Exemplarily, electron-poor compounds such as, e.g., benzimidazoles, pyridines, triazoles, oxadiazoles (e.g., 1,3,4-oxadiazole), phosphinoxides and sulfone, may be used. An electron transporter may also be a star-shaped heterocycle such as 1,3,5-tri(1-phenyl-1H-benzo[d]imidazol-2-yl)phenyl (TPBi). The ETL may comprise NBphen (2,9-bis(naphthalen-2-yl)-4,7-diphenyl-1,10-phenanthroline), Alq₃ (Aluminum-tris(8-hydroxyquinoline)), TSPO1 (diphenyl-4-triphenylsilylphenyl-phosphinoxide), BPyTP2 (2,7-di(2,2'-bipyridin-5-yl)triphenyle), Sif87 (dibenzo[b,d]thiophen-2-yltriphenylsilane), Sif88 (dibenzo[b,d]thiophen-2-yl)diphenylsilane), BmPyPhB (1,3-bis[3,5-di(pyridin-3-yl)phenyl]benzene) and/or BTB (4,4'-bis-[2-(4,6-diphenyl-1,3,5-triazinyl)]-1,1'-biphenyl). Optionally, the ETL may be doped with materials such as Liq. The electron transport layer (ETL) may also block holes or a holeblocking layer (HBL) is introduced.

The HBL may, for example, comprise BCP (2,9-dimethyl-4,7-diphenyl-1,10-phenanthroline = Bathocuproine), BAlq (bis(8-hydroxy-2-methylquinoline)-(4-phenylphenoxy)aluminum), NBphen (2,9-bis(naphthalen-2-yl)-4,7-diphenyl-1,10-phenanthroline), Alq₃ (Aluminum-tris(8-hydroxyquinoline)), TSPO1 (diphenyl-4-triphenylsilylphenyl-phosphinoxide), T2T (2,4,6-tris(biphenyl-3-yl)-1,3,5-triazine), T3T (2,4,6-tris(triphenyl-3-yl)-1,3,5-triazine), TST (2,4,6-tris(9,9'-spirobifluorene-2-yl)-1,3,5-triazine), and/or TCB/TCP (1,3,5-tris(N-carbazolyl)benzol/ 1,3,5-tris(carbazol)-9-yl) benzene).

Adjacent to the electron transport layer (ETL), a cathode layer C may be located. The cathode layer C may, for example, comprise or may consist of a metal (e.g., Al, Au, Ag, Pt, Cu, Zn, Ni, Fe, Pb, LiF, Ca, Ba, Mg, In, W, or Pd) or a metal alloy. For practical reasons, the cathode layer may also consist of (essentially) intransparent metals such as Mg, Ca or Al. Alternatively or additionally, the cathode layer C may also comprise graphite and or carbon nanotubes (CNTs). Alternatively, the cathode layer C may also consist of nanoscalic silver wires.

An OLED may further, optionally, comprise a protection layer between the electron transport layer (ETL) and the cathode layer C (which may be designated as electron injection layer (EIL)). This layer may comprise lithium fluoride, cesium fluoride, silver, Liq (8-hydroxyquinolinolatolithium), Li₂O, BaF₂, MgO and/or NaF.

Optionally, the electron transport layer (ETL) and/or a hole blocking layer (HBL) may also comprise one or more host compounds H.

In order to modify the emission spectrum and/or the absorption spectrum of the light-emitting layer EML further, the light-emitting layer EML may further comprise one or more further emitter molecules F. Such an emitter molecule F may be any emitter molecule known in the art. Preferably such an emitter molecule F is a molecule with a structure differing from the structure of the molecules according to the invention E. The emitter molecule F may optionally be a TADF emitter. Alternatively, the emitter molecule F may optionally be a fluorescent and/or phosphorescent emitter molecule which is able to shift the emission spectrum and/or the absorption spectrum of the light-emitting layer EML. Exemplarily, the triplet and/or singlet excitons may be transferred from the organic emitter molecule according to the invention to the emitter molecule F before relaxing to the ground state S0 by emitting light typically red-shifted in comparison to the light emitted by an organic molecule. Optionally, the emitter molecule F may also provoke two-photon effects (i.e., the absorption of two photons of half the energy of the absorption maximum).

Optionally, an optoelectronic device (e.g., an OLED) may, for example, be an essentially white optoelectronic device. For example, such white optoelectronic device may comprise at least one (deep) blue emitter molecule and one or more emitter molecules emitting green and/or red light. Then, there may also optionally be energy transmittance between two or more molecules as described above.

As used herein, if not defined more specifically in the particular context, the designation of the colors of emitted and/or absorbed light is as follows:

| | |
|---|---|
| violet: | wavelength range of >380-420 nm; |
| deep blue: | wavelength range of >420-480 nm; |
| sky blue: | wavelength range of >480-500 nm; |
| green: | wavelength range of >500-560 nm; |
| yellow: | wavelength range of >560-580 nm; |
| orange: | wavelength range of >580-620 nm; |
| red: | wavelength range of >620-800 nm. |

With respect to emitter molecules, such colors refer to the emission maximum. Therefore, for example, a deep blue emitter has an emission maximum in the range of from >420 to 480 nm, a sky blue emitter has an emission maximum in the range of from >480 to 500 nm, a green emitter has an emission maximum in a range of from >500 to 560 nm, a red emitter has an emission maximum in a range of from >620 to 800 nm.

A red emitter may preferably have an emission maximum of below 800 nm, more preferably below 700 nm, even more preferably below 665 nm or even below 640 nm. It will typically be above 570 nm, preferably above 590 nm, more preferably above 610 nm or even above 620 nm.

Accordingly, a further aspect of the present invention relates to an OLED, which exhibits an external quantum efficiency at 1000 cd/m² of more than 8 %, more preferably of more than 10 %, more preferably of more than 13 %, even more preferably of more than 15 % or even more than 20 % and/or exhibits an emission maximum between 590 nm and 690 nm, preferably between 610 nm and 665 nm, even more preferably between 620 nm and 640 nm.and/or exhibits a LT80 value at 500 cd/m² of more than 100 h, preferably more than 200 h, more preferably more than 400 h, even more preferably more than 750 h or even more than 1000 h. Accordingly, a further aspect of the present invention relates to an OLED, whose emission exhibits a CIEy color coordinate of more than 0.25, preferably more than 0.27, more preferably more than 0.29 or even more preferably more than 0.30.

A further embodiment of the present invention relates to an OLED, which emits light with CIEx and CIEy color coordinates close to the CIEx (= 0.708) and CIEy (= 0.292) color coordinates of the primary color red (CIEx = 0.708 and CIEy = 0.292) as defined by ITU-R Recommendation BT.2020 (Rec. 2020) and thus is suited for the use in Ultra High Definition (UHD) displays, e.g. UHD-TVs. In this context, the term "close to" refers to the ranges of CIEx and CIEy coordinates provided at the end of this paragraph. In commercial applications, typically top-emitting (top-electrode is transparent) devices are used, whereas test devices as used throughout the present application represent bottom-emitting devices (bottom-electrode and substrate are transparent). Accordingly, a further aspect of the present invention relates to an OLED, whose emission exhibits a CIEx color coordinate of between 0.60 and 0.88, preferably between 0.61 and 0.83, more preferably between 0.63 and 0.78 or even more preferably between 0.66 and 0.76 or even between 0.68 and 0.73 and/ or a CIEy color coordinate of between 0.25 and 0.70, preferably between 0.26 and 0.55, more preferably between 0.27 and 0.45 or even more preferably between 0.28 and 0.40 or even between 0.29 and 0.35.

Accordingly, a further aspect of the present invention relates to an OLED, which exhibits an external quantum efficiency at 14500 cd/m² of more than 10%, more preferably of more than 13%, more preferably of more than 15%, even more preferably of more than 17% or even more than 20% and/or exhibits an emission maximum between 590 nm and 690 nm, preferably between 610 nm and 665 nm, even more preferably between 620 nm and 640 nm.

A further aspect of the present invention relates to an OLED, which emits light at a distinct color point. According to the present invention, the OLED emits light with a narrow emission band (small full width at half maximum (FWHM)). In one aspect, the OLED according to the invention emits light with a FWHM of the main emission peak of less than 0.30 eV, preferably less than 0.25 eV, more preferably less than 0.20 eV, even more preferably less than 0.19 eV or even less than 0.17 eV.

In a further aspect, the invention relates to a method for producing an optoelectronic component. In this case an organic molecule of the invention is used.

The optoelectronic device, in particular the OLED according to the present invention can be fabricated by any means of vapor deposition and/ or liquid processing. Accordingly, at least one layer is
- prepared by means of a sublimation process,
- prepared by means of an organic vapor phase deposition process,
- prepared by means of a carrier gas sublimation process,
- solution processed or printed.

The methods used to fabricate the optoelectronic device, in particular the OLED according to the present invention are known in the art. The different layers are individually and successively deposited on a suitable substrate by means of subsequent deposition processes. The individual layers may be deposited using the same or differing deposition methods.

Vapor deposition processes, for example, comprise thermal (co)evaporation, chemical vapor deposition and physical vapor deposition. For active matrix OLED display, an AMOLED backplane is used as substrate. The individual layer may be processed from solutions or dispersions employing adequate solvents. Solution deposition process, for example, comprise spin coating, dip coating and jet printing. Liquid processing may optionally be carried out in an inert atmosphere (e.g., in a nitrogen atmosphere) and the solvent may be completely or partially removed by means known in the state of the art.

### Examples

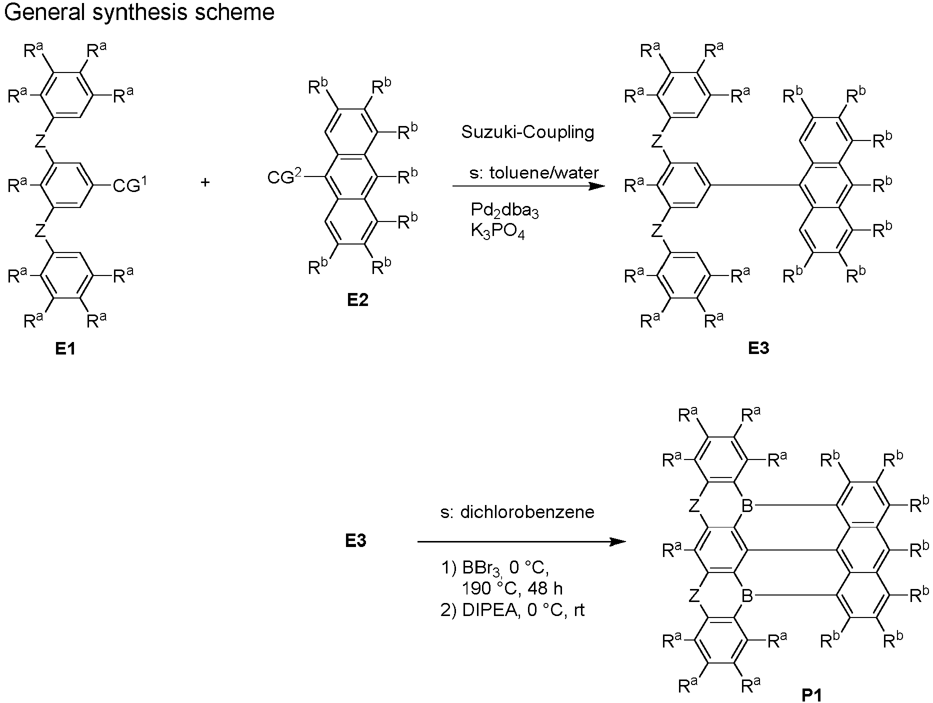

The coupling groups CG¹ and CG² are chosen as a reaction pair to introduce the heterocycle of E2 at the position of CG¹. Preferably, a so-called Suzuki coupling reaction is used. Here, either CG¹ is chosen from Cl, Br or I, and CG² is a boronic acid group or a boronic acid ester group, in particular a boronic acid pinacol ester group, or CG¹ is a boronic acid group or a boronic acid ester group, in particular a boronic acid pinacol ester group, and CG² is chosen from CI, Br or I.

In E1, E2, E3 and P1, R^{a}, R^{b}, and Z are the same as described in connection with Formula I.

### General procedure for synthesis:

### AAV1-1:

E1 (1.00 equivalents, e.g. 5-bromo-N1,N1,N3,N3-tetraphenyl-1,3-benzenediamine, CAS 1290039-73-4), E2 (1.20 equivalents; e.g. (10-phenylanthracen-9-yl)boronic acid, CAS: 1290039-73-4), tris(dibenzylideneacetone)dipalladium(0) (0.01 equivalents; CAS: 51364-51-3), S-Phos (0.04 equivalents; CAS: 657408-07-6) and potassium phosphate (K₃PO₄ ; CAS: 7778-53-2, 2.00 equivalents) are stirred under nitrogen atmosphere in toluene/water at 95 °C for 72 h. After cooling down to room temperature (rt), the reaction mixture is extracted between ethyl acetate and water. The organic phases were collected, dried over MgSO₄, treated with Celite^{®} and charcoal, stirred for 1 h and filtered. The combined organic layers concentrated under reduced pressure. The crude is purified by column chromatography or recrystallization and E3 is obtained as a solid.

AAV2: A solution of E-3 (1.0 equivalent) in dry 1,2-dichlorobenzene (35 mL per 1 mmol E-3) was added boron tribromide (99%, CAS-No. 10294-33-4, 4.0 equivalents). The mixture was allowed to warm to rt, followed by heating to 190 °C for 48 h. The mixture was allowed to cool down to rt. Subsequently, the mixture was extracted between brine/water and dichloromethane and the combined organic layers were dried over MgSO₄, filtered and concentrated. After purification through recrystallization or column chromatography, the target compound P-1 was obtained as a solid.

### Cyclic voltammetry

Cyclic voltammograms are measured from solutions having concentration of 10⁻³ mol/L of the organic molecules in dichloromethane or a suitable solvent and a suitable supporting electrolyte (e.g. 0.1 mol/L of tetrabutylammonium hexafluorophosphate). The measurements are conducted at room temperature under nitrogen atmosphere with a three-electrode assembly (Working and counter electrodes: Pt wire, reference electrode: Pt wire) and calibrated using FeCp₂/FeCp₂⁺ as internal standard. The HOMO data was corrected using ferrocene as internal standard against a saturated calomel electrode (SCE).

### Density functional theory calculation

Molecular structures are optimized employing the BP86 functional and the resolution of identity approach (RI). Excitation energies are calculated using the (BP86) optimized structures employing Time-Dependent DFT (TD-DFT) methods. Orbital and excited state energies are calculated with the B3LYP functional. Def2-SVP basis sets (and a m4-grid for numerical integration are used. The Turbomole program package is used for all calculations.

### Photophysicalmeasurements

Sample pretreatment: Spin-coating
Apparatus: Spin150, SPS euro.
The sample concentration is 0.2 mg/ml, dissolved in Toluene/DCM.
Program: 7 ) 30sec. at 2000 U/min. After coating, the films are tried at 70 °C for 1 min.

### Fluorescence Spectroscopy and Phosphorescence Spectroscopy

For the analysis of Phosphorescence and Photoluminescence spectroscopy a fluorescence spectrometer "Fluoromax 4P" from Horiba is used.

### Time-resolved PL spectroscopy in the µs-range and ns-range (FS5)

Time-resolved PL measurements were performed on a FS5 fluorescence spectrometer from Edinburgh Instruments. Compared to measurements on the HORIBA setup, better light gathering allows for an optimized signal to noise ratio, which favors the FS5 system especially for transient PL measurements of delayed fluorescence characteristics. The FS5 consists of a xenon lamp providing a broad spectrum. The continuous light source is a 150W xenon arc lamp, selected wavelengths are chosen by a Czerny-Turner monochromator, which is also used to set specific emission wavelengths. The sample emission is directed towards a sensitive R928P photomultiplier tube (PMT), allowing the detection of single photons with a peak quantum efficiency of up to 25 % in the spectral range between 200 nm to 870 nm. The detector is a temperature stabilized PMT, providing dark counts below 300 cps (counts per second). Finally, to determine the transient decay lifetime of the delayed fluorescence, a tail fit using three exponential functions is applied. By weighting the specific lifetimes *τᵢ* with their corresponding amplitudes *Aᵢ*, ${τ}_{DF} = {\sum }_{i = 1}^{3} \frac{{A}_{i} {τ}_{i}}{{A}_{i}}$ **the delayed** fluorescence lifetime *τ*_{DF} is determined.

### Photoluminescence quantum yield measurements

For photoluminescence quantum yield (PLQY) measurements an Absolute PL Quantum Yield Measurement C9920-03G system *(Hamamatsu Photonics)* is used. Quantum yields and CIE coordinates are determined using the software U6039-05 version 3.6.0.

Emission maxima are given in nm, quantum yields Φ in % and CIE coordinates as x,y values. PLQY is determined using the following protocol:
1) Quality assurance: Anthracene in ethanol (known concentration) is used as reference
2) Excitation wavelength: the absorption maximum of the organic molecule is determined and the molecule is excited using this wavelength
3) Measurement
   Quantum yields are measured, for sample, of solutions or films under nitrogen atmosphere. The yield is calculated using the equation: ${Φ}_{PL} = \frac{{n}_{photon} , emitted}{{n}_{photon} , absorbed} = \frac{\int \frac{λ}{hc} \left[{Int}_{emitted}^{sample}\left(λ\right)-{I}_{absorbed}^{sample}\left(λ\right)\right] dλ}{\int \frac{λ}{hc} \left[{Int}_{emitted}^{reference}\left(λ\right)-{I}_{absorbed}^{reference}\left(λ\right)\right] dλ}$ wherein nₚₕₒₜₒₙ denotes the photon count and Int. the intensity.

### Measurement of the Emission spectrum

The material was dissolved in chloroform and the solution filtered through a syringe filter. Remaining solution was used to spin coat a 2% film in PMMA. Sample was excited at 291 nm and a 495 nm filter was used for the measurement.

### Production and characterization of optoelectronic devices

Optoelectronic devices, such as OLED devices, comprising organic molecules according to the invention can be produced via vacuum-deposition methods. If a layer contains more than one compound, the weight-percentage of one or more compounds is given in %. The total weight-percentage values amount to 100 %, thus if a value is not given, the fraction of this compound equals to the difference between the given values and 100 %.

The not fully optimized OLEDs are characterized using standard methods and measuring electroluminescence spectra, the external quantum efficiency (in %) in dependency on the intensity, calculated using the light detected by the photodiode, and the current. The OLED device lifetime is extracted from the change of the luminance during operation at constant current density. The LT50 value corresponds to the time, where the measured luminance decreased to 50 % of the initial luminance, analogously LT80 corresponds to the time point, at which the measured luminance decreased to 80 % of the initial luminance, LT 95 to the time point, at which the measured luminance decreased to 95 % of the initial luminance etc.

Accelerated lifetime measurements are performed (e.g. applying increased current densities). For example, LT80 values at 500 cd/m² are determined using the following equation: $LT 80 \left(500\frac{{cd}^{2}}{{m}^{2}}\right) = LT 80 \left({L}_{0}\right) {\left(\frac{{L}_{0}}{500 \frac{{cd}^{2}}{{m}^{2}}}\right)}^{1.6}$ wherein *L₀* denotes the initial luminance at the applied current density.

The values correspond to the average of several pixels (typically two to eight), the standard deviation between these pixels is given.

### HPLC-MS

HPLC-MS analysis is performed on an HPLC by Agilent (1260 series) with MS-detector (Thermo LTQ XL).

For example, a typical HPLC method is as follows: a reverse phase column 3.0 mm x 100 mm, particle size 2.7 µm from Agilent *(Poroshell 120EC-C18, 3.0 x 100 mm, 2.7 µm HPLC column)* is used in the HPLC. The HPLC-MS measurements are performed at room temperature (rt) following gradients

| **Flow rate [ml/min]** | **Time [min]** | **A[%]** | **B[%]** | **C[%]** |
|---|---|---|---|---|
| 1.5 | 30 | 40 | 40 | 30 |
| 1.5 | 45 | 10 | 10 | 80 |
| 1.5 | 50 | 40 | 10 | 80 |
| 1.5 | 51 | 30 | 40 | 30 |
| 1.5 | 55 | 30 | 10 | 30 |

using the following solvent mixtures containing 0.1% formic acid:

| | | |
|---|---|---|
| Solvent A: | H₂O (10%) | MeCN (90%) |
| Solvent B: | H₂O (90%) | MeCN (10%) |
| Solvent C: | THF (50%) | MeCN (50%) |

An injection volume of 2 µL from a solution with a concentration of 0.5 mg/mL of the analyte is taken for the measurements.

Ionization of the probe is performed using an atmospheric pressure chemical ionization (APCI) source either in positive (APCI +) or negative (APCI -) ionization mode or an atmospheric pressure photoionization (APPI) source.

### Example 1

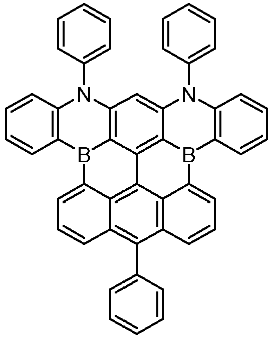

Example 1 was synthesized according to General synthesis scheme and according to
*AAV1* (46% yield), wherein 5-bromo-N1,N1,N3,N3-tetraphenyl-1,3-benzenediamine (CAS 1290039-73-4) was used as reactant E1 and (10-phenylanthracen-9-yl)boronic acid (CAS 1290039-73-4) was used as reactant E2; and
AAV2 (2% yield).

MS (HPLC-MS), m/z (retention time): 681 (6.63 min).

The emission maximum (λₘₐₓ) of example 1 (0.005 mg/mL in toluene) is at 658 nm, the full width at half maximum (FWHM) is 82 nm (0.22 eV), and the photoluminescence quantum yield (PLQY) is 38%.

### Additional Examples of Organic Molecules of the Invention

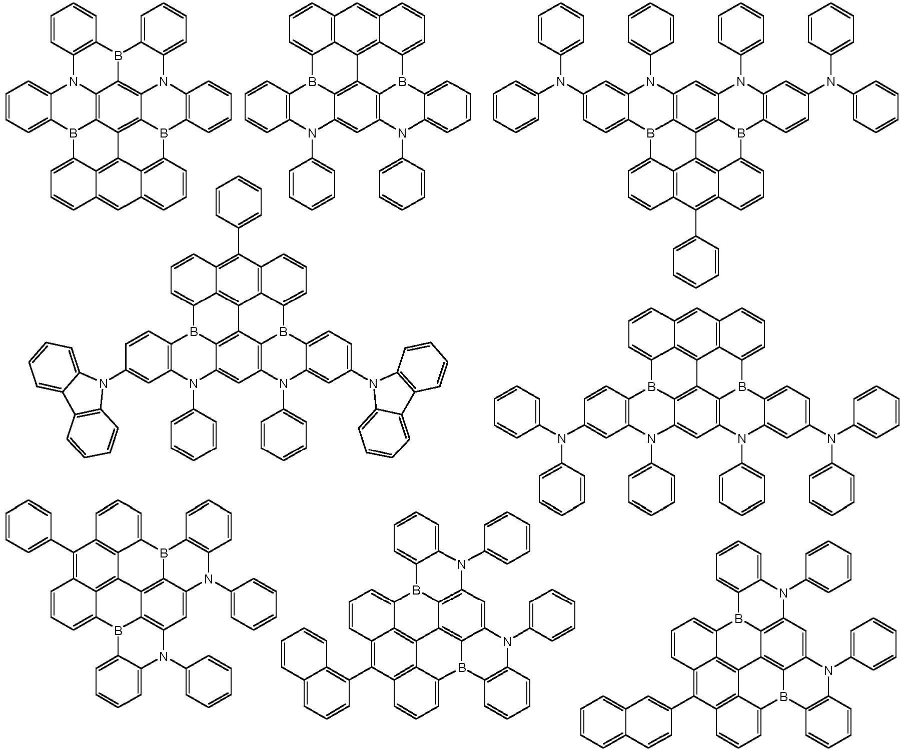

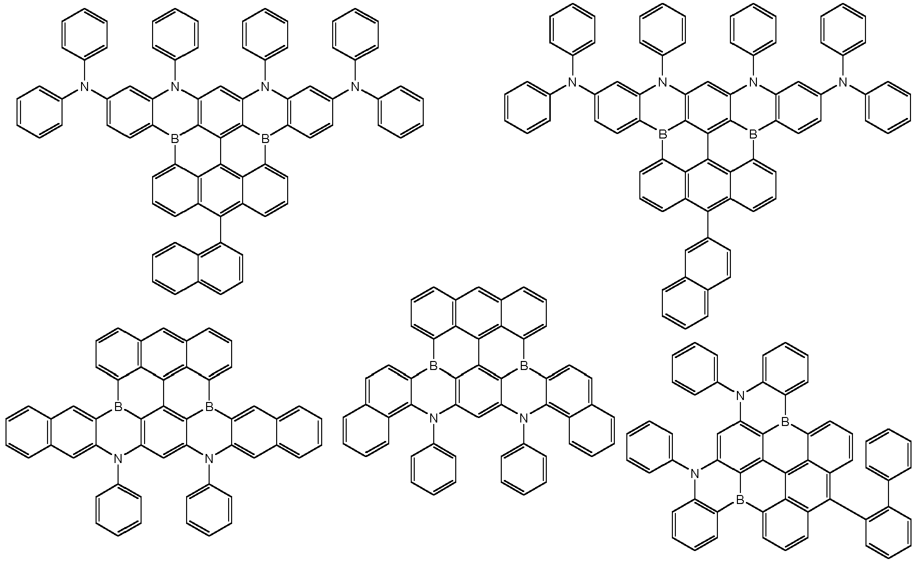

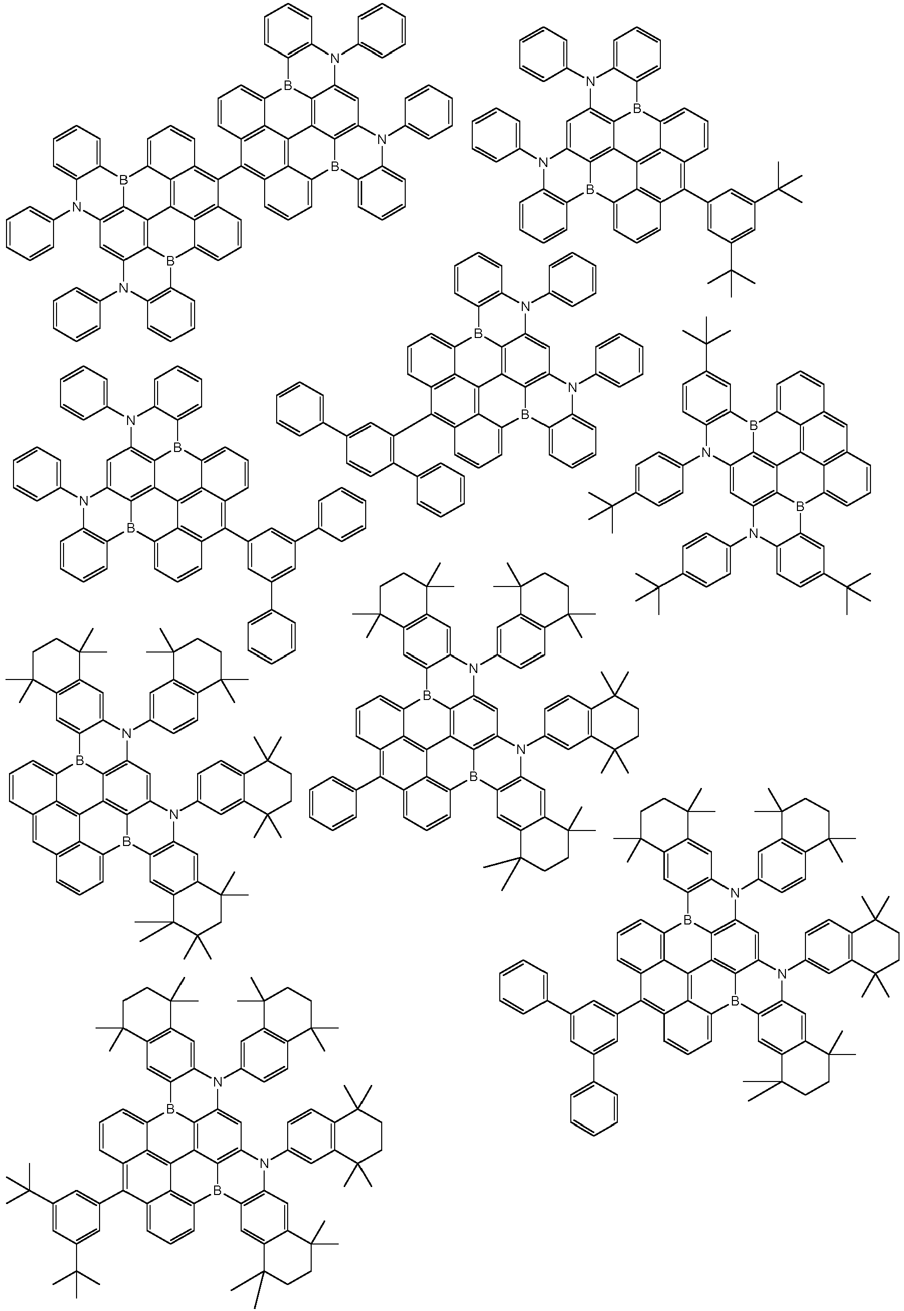

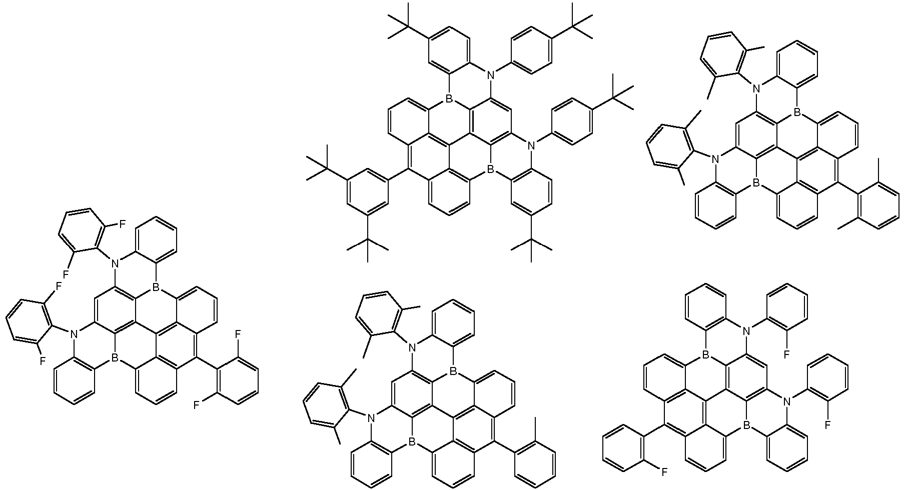

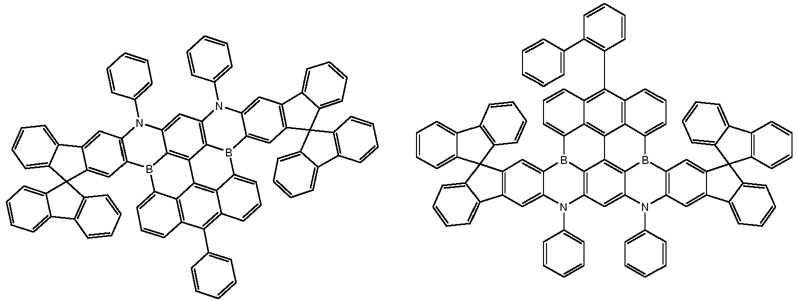

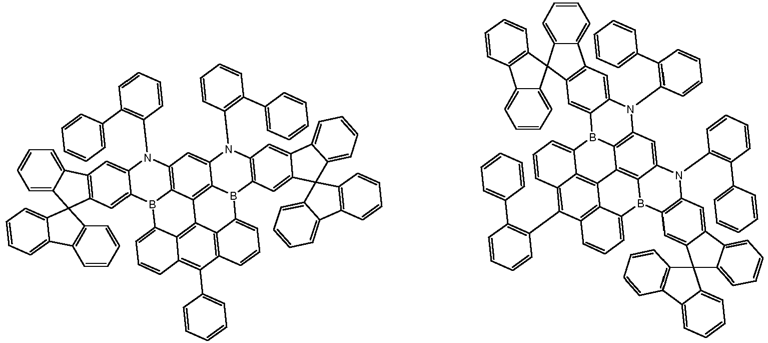

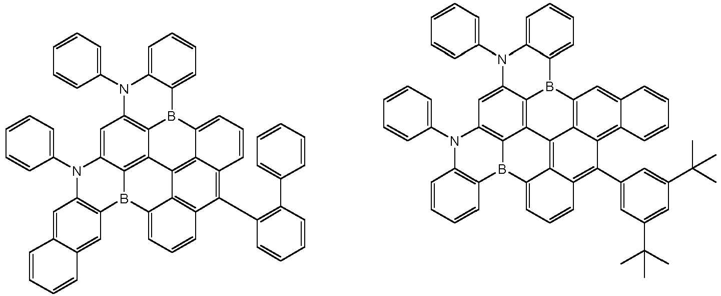

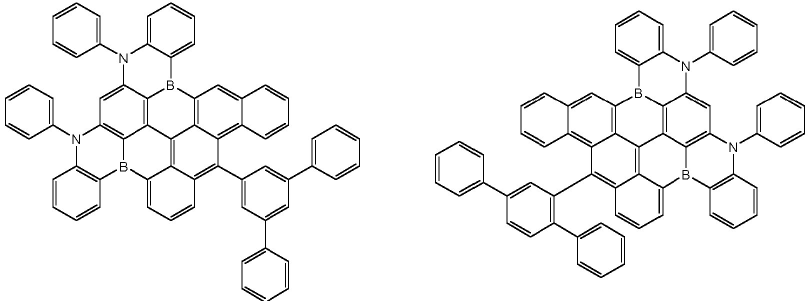

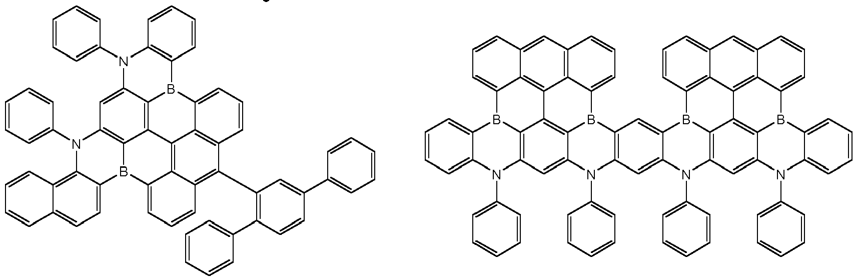

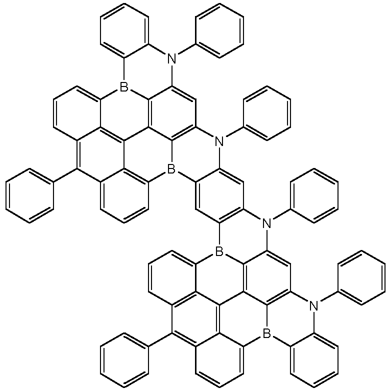

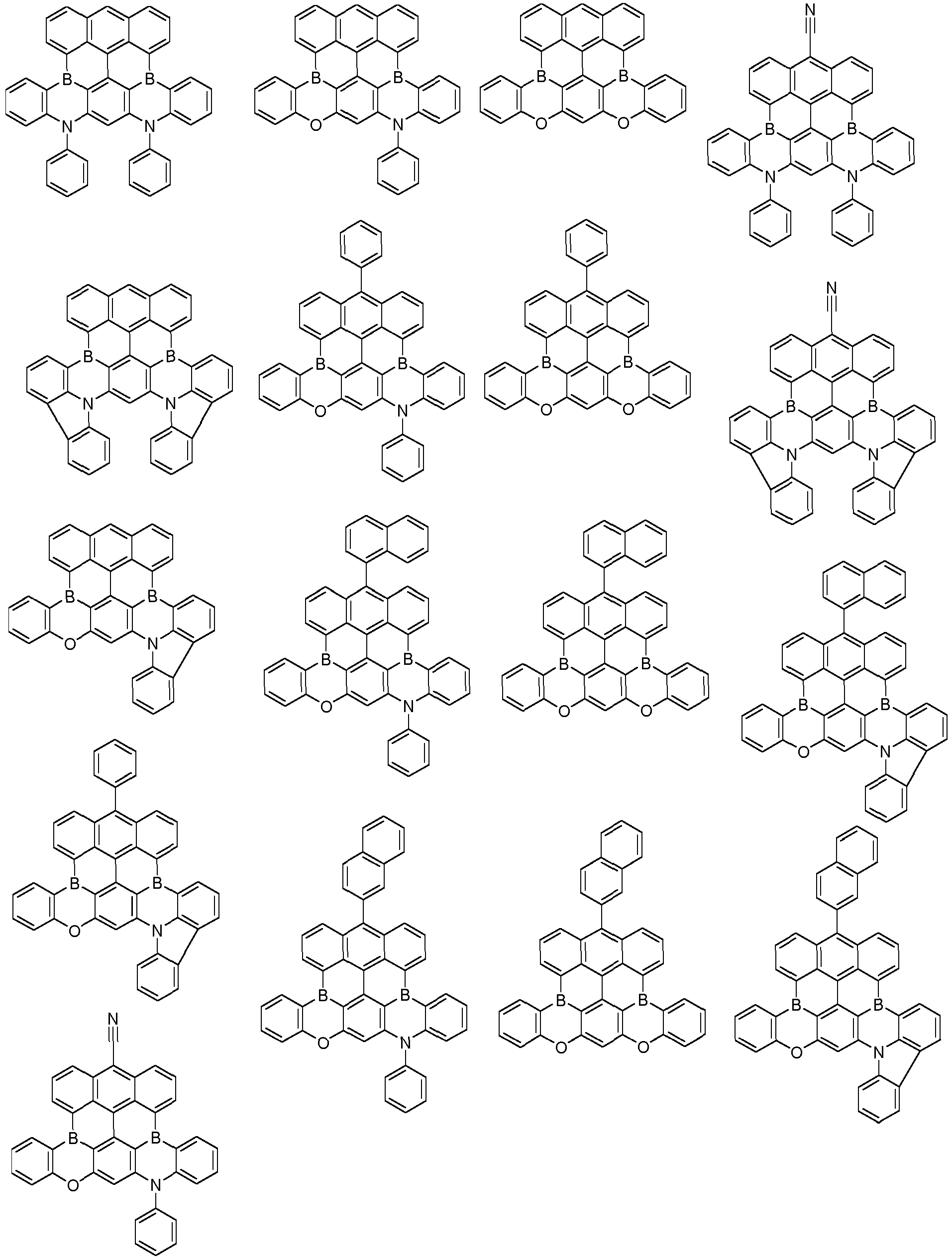

## Claims

1. An organic molecule, comprising of a structure of formula I: 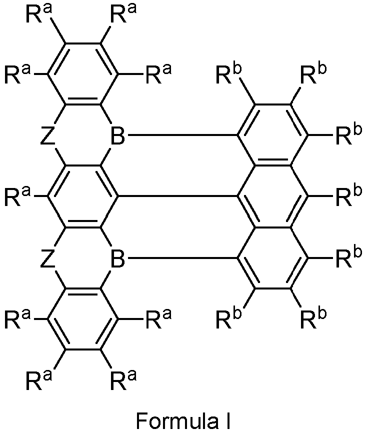
Z is, at each occurrence, independently selected from the group consisting of a direct bond, NR^{a}, O, and S; and
R^{a} and R^{b} are, at each occurrence, independently selected from the group consisting of:
hydrogen, deuterium, N(R⁵)₂, OR⁵, Si(R⁵)₃, B(OR⁵)₂, B(R⁵)₂, OSO₂R⁵, CF₃, CN, F, Br, I,
C₁-C₄₀-alkyl,
which is optionally substituted with one or more R⁵ substituents and
wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₁-C₄₀-alkoxy,
which is optionally substituted with one or more R⁵ substituents and
wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₁-C₄₀-thioalkoxy,
which is optionally substituted with one or more R⁵ substituents and
wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₂-C₄₀-alkenyl,
which is optionally substituted with one or more R⁵ substituents and
wherein one or more non-adjacent CH₂-groups are optionally substituted by R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₂-C₄₀-alkynyl,
which is optionally substituted with one or more R⁵ substituents and
wherein one or more non-adjacent CH₂-groups are optionally substituted by R⁵C=CR⁵, C≡C, Si(R⁵)₂, Ge(R⁵)₂, Sn(R⁵)₂, C=O, C=S, C=Se, C=NR⁵, P(=O)(R⁵), SO, SO₂, NR⁵, O, S or CONR⁵;
C₆-C₆₀-aryl,
which is optionally substituted with one or more R⁵ substituents; and
C₂-C₅₇-heteroaryl,
which is optionally substituted with one or more R⁵ substituents;
R⁵ is, at each occurrence, independently selected from the group consisting of: hydrogen, deuterium, N(R⁶)₂, OR⁶, Si(R⁶)₃, B(OR⁶)₂, B(R⁶)₂, OSO₂R⁶, CF₃, CN, F, Br, I,
C₁-C₄₀-alkyl,
which is optionally substituted with one or more R⁶ substituents and
wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₁-C₄₀-alkoxy,
which is optionally substituted with one or more R⁶ substituents and
wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₁-C₄₀-thioalkoxy,
which is optionally substituted with one or more R⁶ substituents and
wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₂-C₄₀-alkenyl,
which is optionally substituted with one or more R⁶ substituents and
wherein one or more non-adjacent CH₂-groups are optionally substituted by R⁶C=CR⁶, C≡C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₂-C₄₀-alkynyl,
which is optionally substituted with one or more R⁶ substituents and
wherein one or more non-adjacent CH₂-groups are optionally substituted by R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S or CONR⁶;
C₆-C₆₀-aryl,
which is optionally substituted with one or more R⁶ substituents; and
C₂-C₅₇-heteroaryl,
which is optionally substituted with one or more R⁶ substituents;
R⁶ is, at each occurrence, independently selected from the group consisting of: hydrogen, deuterium, OPh, CF₃, CN, F,
C₁-C₅-alkyl,
wherein one or more hydrogen atoms are optionally, independently substituted by deuterium, CN, CF₃, or F;
C₁-C₅-alkoxy,
wherein one or more hydrogen atoms are optionally, independently substituted by deuterium, CN, CF₃, or F;
C₁-C₅-thioalkoxy,
wherein one or more hydrogen atoms are optionally, independently substituted by deuterium, CN, CF₃, or F;
C₂-C₅-alkenyl,
wherein one or more hydrogen atoms are optionally, independently substituted by deuterium, CN, CF₃, or F;
C₂-C₅-alkynyl,
wherein one or more hydrogen atoms are optionally, independently substituted by deuterium, CN, CF₃, or F;
C₆-C₁₈-aryl,
which is optionally substituted with one or more C₁-C₅-alkyl substituents;
C₂-C₁₇-heteroaryl,
which is optionally substituted with one or more C₁-C₅-alkyl substituents;
N(C₆-C₁₈-aryl)₂;
N(C₂-C₁₇-heteroaryl)₂, and
N(C₂-C₁₇-heteroaryl)(C₆-C₁₈-aryl);
wherein optionally any of the substituents R^{a}, R^{b}, R⁵, and R⁶ independently form a mono- or polycyclic, aliphatic, aromatic, heteroaromatic and/or benzo-fused ring system with one or more substituents R^{a}, R^{b}, R⁵ and/or R⁶.

2. An organic molecule according to claim 1, comprising a structure of formula II-1 or formula II-2: 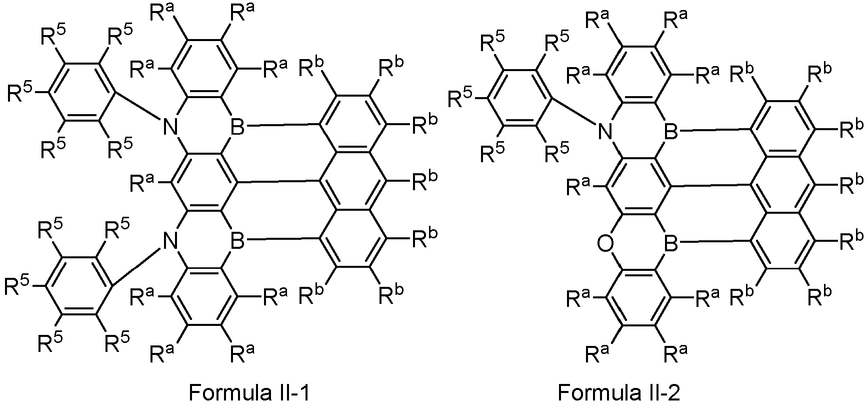 wherein, in formula II-1 and formula II-2, R^{a}, R^{b}, and R⁵ are the same as described in connection with Formula I.

3. An organic molecule according to claims 1 or 2, wherein R⁵ is, at each occurrence, independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

4. An organic molecule according to any of claims 1 to 3, wherein R⁵ is, at each occurrence, independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

5. An organic molecule according to any of claims 1 to 4, comprising a structure of formula IIa-1: 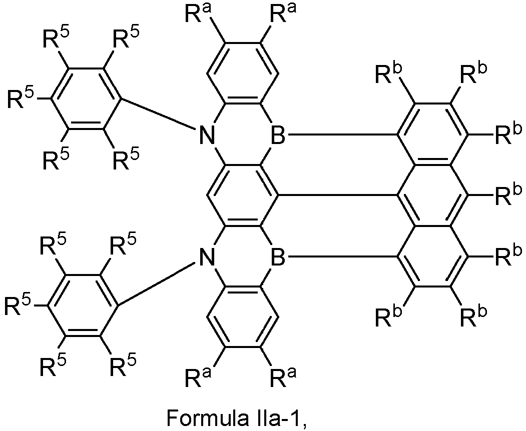 wherein, in formula IIa-1, R^{a}, R^{b}, and R⁵ are the same as described in connection with Formula I, and adjacent R^{a} substituents independently form a mono- or polycyclic, aliphatic, aromatic, heteroaromatic and/or benzo-fused ring system.

6. An organic molecule according to any of claims 1 to 5, comprising a structure of formula V-1, formula V-2 or formula V-3: 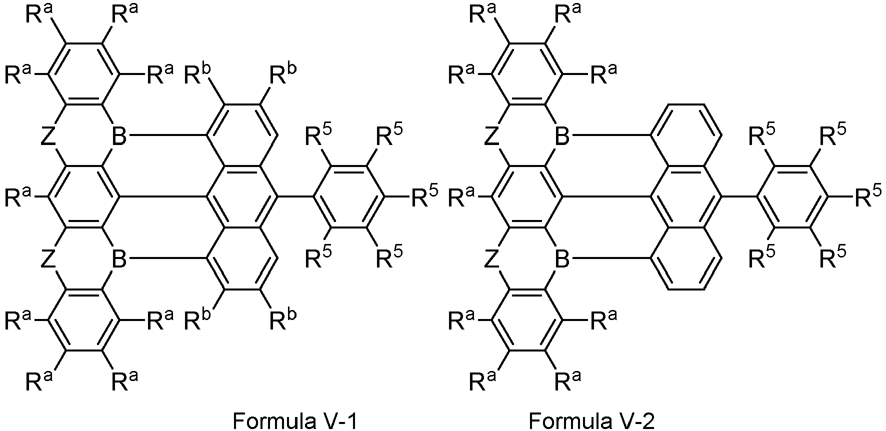 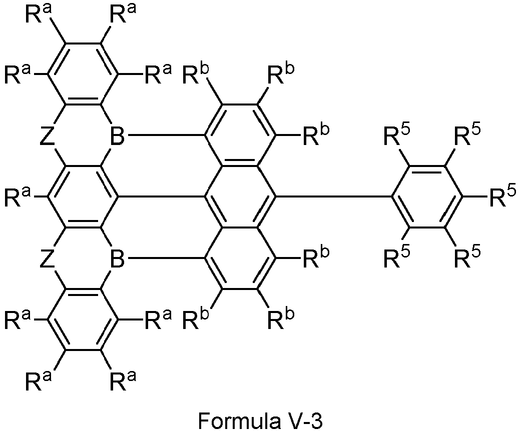 wherein, in formula V-1, formula V-2, and formula V-3, Z, R^{a}, R^{b}, and R⁵ are the same as described in connection with Formula I.

7. An organic molecule according to any of claims 1 to 6, wherein R^{b} is, at each occurrence, independently selected from the group consisting of:
hydrogen,
Me,
ⁱPr,
^{t}Bu,
CN,
CF₃,
Ph, which is optionally substituted with one or more substituents independently selected from the group consisting of Me, ⁱPr, ^{t}Bu, CN, CF₃, and Ph,
pyridinyl, which is optionally substituted with one or more substituents independently selected from the group consisting of Me, ⁱPr, ^{t}Bu, CN, CF₃, and Ph,
pyrimidinyl, which is optionally substituted with one or more substituents independently selected from the group consisting of Me, ⁱPr, ^{t}Bu, CN, CF₃, and Ph,
carbazolyl, which is optionally substituted with one or more substituents independently selected from the group consisting of Me, ⁱPr, ^{t}Bu, CN, CF₃, and Ph,
triazinyl, which is optionally substituted with one or more substituents independently selected from the group consisting of Me, ⁱPr, ^{t}Bu, CN, CF₃, and Ph,
and N(Ph)₂.

8. An oligomer, comprising a plurality of organic molecules according to any of claims 1 to 7 as units, wherein each unit comprises or consists of a structure represent by formula VI 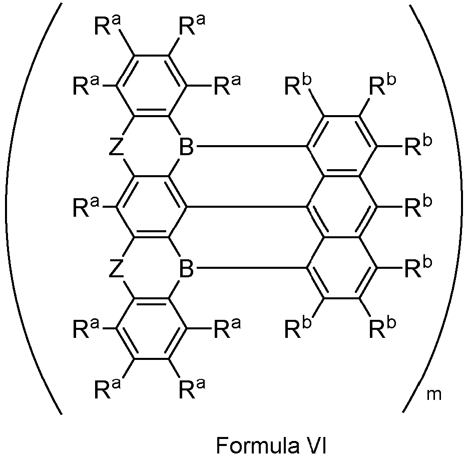 wherein, in formula VI, Z, R^{a}, and R^{b} are the same as described in connection with Formula I, and m is an integer from 2 to 6.

9. Use of an organic molecule according to any of claims 1 to 8 as a luminescent emitter in an optoelectronic device.

10. The use according to claim 9, wherein the optoelectronic device is selected from the group consisting of:
• organic light-emitting diodes (OLEDs),
• light-emitting electrochemical cells,
• OLED-sensors,
• organic diodes,
• organic solar cells,
• organic transistors,
• organic field-effect transistors,
• organic lasers, and
• down-conversion elements.

11. A composition, comprising:
(a) an organic molecule according to any of claims 1 to 8, in particular in the form of an emitter and/or a host,
(b) an emitter and/or a host material, which differs from the organic molecule, and
(c) optionally, a dye and/or a solvent.

12. An optoelectronic device, comprising an organic molecule according to any of claims 1 to 8 or a composition according to claim 11, in particular in the form of a device selected from the group consisting of organic light-emitting diode (OLED), light-emitting electrochemical cell, OLED-sensor, organic diode, organic solar cell, organic transistor, organic field-effect transistor, organic laser, and down-conversion element.

13. An optoelectronic device according to claim 12, comprising:
- a substrate,
- an anode, and
- a cathode, wherein the anode or the cathode is disposed on the substrate, and
- a light-emitting layer, which is arranged between the anode and the cathode and which comprises the organic molecule or the composition.

14. A method for producing an optoelectronic device, wherein an organic molecule according to any one of claims 1 to 8 or a composition according to claim 11 is used.

15. The method according to claim 14, comprising the processing of the organic molecule by a vacuum evaporation method or from a solution.

## Patentansprüche

1. Organisches Molekül, umfassend eine Struktur der Formel I: 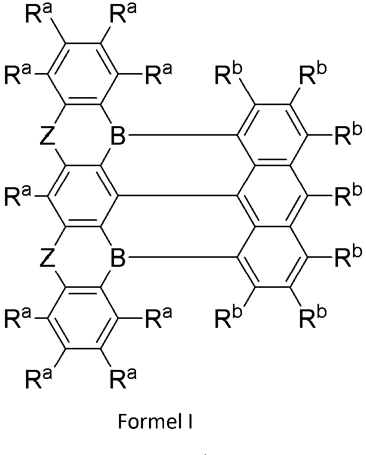
wobei Z bei jedem Auftreten unabhängig ausgewählt ist aus der Gruppe bestehend aus einer direkten Bindung, NR^{a}, O, und S; und
R^{a} und R^{b} bei jedem Auftreten unabhängig ausgewählt sind aus der Gruppe bestehend aus: Wasserstoff, Deuterium, N(R⁵)₂, OR⁵, Si(R⁵)₃, B(OR⁵)₂, B(R⁵)₂, OSO₂R⁵, CF₃, CN, F, Br, I,
C₁-C₄₀-Alkyl,
das optional mit einem oder mehreren R⁵-Substituenten substituiert ist und
wobei eine oder mehrere nicht benachbarte CH₂-Gruppen optional substituiert sind durch R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S oder CONR⁵;
C₁-C₄₀-Alkoxy,
das optional mit einem oder mehreren R⁵-Substituenten substituiert ist und
wobei eine oder mehrere nicht benachbarte CH₂-Gruppen optional substituiert sind durch R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S oder CONR⁵;
C₁-C₄₀-Thioalkoxy,
das optional mit einem oder mehreren R⁵-Substituenten substituiert ist und
wobei eine oder mehrere nicht benachbarte CH₂-Gruppen optional substituiert sind durch R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S oder CONR⁵;
C₂-C₄₀-Alkenyl,
das optional mit einem oder mehreren R⁵-Substituenten substituiert ist und
wobei eine oder mehrere nicht benachbarte CH₂-Gruppen optional substituiert sind durch R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S oder CONR⁵;
C₂-C₄₀-Alkinyl,
das optional mit einem oder mehreren R⁵-Substituenten substituiert ist und
wobei eine oder mehrere nicht benachbarte CH₂-Gruppen optional substituiert sind durch R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S oder CONR⁵;
C₆-C₆₀-Aryl,
das optional mit einem oder mehreren R⁵-Substituenten substituiert ist; und
C₂-C₅₇-Heteroaryl,
das optional mit einem oder mehreren R⁵-Substituenten substituiert ist;
wobei R⁵ bei jedem Auftreten unabhängig ausgewählt ist aus der Gruppe bestehend aus: Wasserstoff, Deuterium, N(R⁶)₂, OR⁶, Si(R⁶)₃, B(OR⁶)₂, B(R⁶)₂, OSO₂R⁶, CF₃, CN, F, Br, I,
C₁-C₄₀-Alkyl,
das optional mit einem oder mehreren R⁶-Substituenten substituiert ist und
wobei eine oder mehrere nicht benachbarte CH₂-Gruppen optional substituiert sind durch R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶;
C₁-C₄₀-Alkoxy,
das optional mit einem oder mehreren R⁶-Substituenten substituiert ist und
wobei eine oder mehrere nicht benachbarte CH₂-Gruppen optional substituiert sind durch R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶;
C₁-C₄₀-Thioalkoxy,
das optional mit einem oder mehreren R⁶-Substituenten substituiert ist und
wobei eine oder mehrere nicht benachbarte CH₂-Gruppen optional substituiert sind durch R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶;
C₂-C₄₀-Alkenyl,
das optional mit einem oder mehreren R⁶-Substituenten substituiert ist und
wobei eine oder mehrere nicht benachbarte CH₂-Gruppen optional substituiert sind durch R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶;
C₂-C₄₀-Alkinyl,
das optional mit einem oder mehreren R⁶-Substituenten substituiert ist und
wobei eine oder mehrere nicht benachbarte CH₂-Gruppen optional substituiert sind durch R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S oder CONR⁶;
C₆-C₆₀-Aryl,
das optional mit einem oder mehreren R⁶-Substituenten substituiert ist; und
C₂-C₅₇-Heteroaryl,
das optional mit einem oder mehreren R⁶-Substituenten substituiert ist;
wobei R⁶ bei jedem Auftreten unabhängig ausgewählt ist aus der Gruppe bestehend aus Wasserstoff, Deuterium, OPh, CF₃, CN, F,
C₁-C₅-Alkyl,
wobei ein oder mehrere Wasserstoffatome optional unabhängig substituiert sind durch Deuterium, CN, CF₃ oder F;
C₁-C₅-Alkoxy,
wobei ein oder mehrere Wasserstoffatome optional unabhängig substituiert sind durch Deuterium, CN, CF₃ oder F;
C₁-C₅-Thioalkoxy,
wobei ein oder mehrere Wasserstoffatome optional unabhängig substituiert sind durch Deuterium, CN, CF₃ oder F;
C₂-C₅-Alkenyl,
wobei ein oder mehrere Wasserstoffatome optional unabhängig substituiert sind durch Deuterium, CN, CF₃ oder F;
C₂-C₅-Alkinyl,
wobei ein oder mehrere Wasserstoffatome optional unabhängig substituiert sind durch Deuterium, CN, CF₃ oder F;
C₆-C₁₈-Aryl,
das optional mit einem oder mehreren C₁-C₅-Alkylsubstituenten substituiert ist;
C₂-C₁₇-Heteroaryl,
das optional mit einem oder mehreren C₁-C₅-Alkylsubstituenten substituiert ist;
N(C₆-C₁₈-Aryl)₂;
N(C₂-C₁₇-Heteroaryl)₂ und
N(C₂-C₁₇-Heteroaryl)(C₆-C₁₈-Aryl);
wobei jeglicher der Substituenten R^{a}, R^{b}, R⁵und R⁶ optional unabhängig ein mono- oder polycyclisches, aliphatisches, aromatisches, heteroaromatisches und/oder benzokondensiertes Ringsystem mit einem oder mehreren Substituenten R^{a}, R^{b}, R⁵ und/oder R⁶ bilden kann.

2. Organisches Molekül nach Anspruch 1, umfassend eine Struktur der Formel II-1 oder Formel II-2: 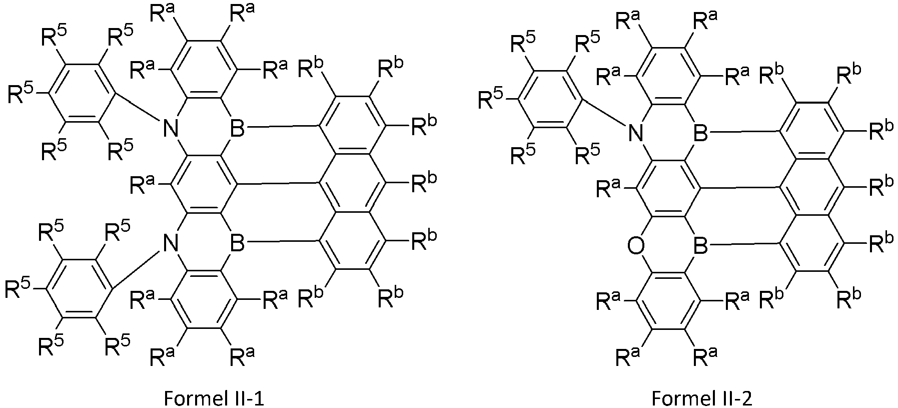 wobei in Formel II-1 und Formel II-2 R^{a}, R^{b} und R⁵ die gleichen sind wie in Zusammenhang mit Formel I beschrieben.

3. Organisches Molekül nach Ansprüchen 1 oder 2, wobei R⁵ bei jedem Auftreten unabhängig ausgewählt ist aus der Gruppe bestehend aus:
Wasserstoff,
Me,
ⁱPr,
^{t}Bu,
CN,
CF₃,
Ph, das optional mit einem oder mehreren Substituenten substituiert ist, unabhängig ausgewählt aus der Gruppe bestehend aus Me, ⁱPr, ^{t}Bu, CN, CF₃und Ph,
Pyridinyl, das optional mit einem oder mehreren Substituenten substituiert ist, unabhängig ausgewählt aus der Gruppe bestehend aus Me, ⁱPr, ^{t}Bu, CN, CF₃ und Ph,
Pyrimidinyl, das optional mit einem oder mehreren Substituenten substituiert ist, unabhängig ausgewählt aus der Gruppe bestehend aus Me, ⁱPr, ^{t}Bu, CN, CF₃ und Ph,
Carbazolyl, das optional mit einem oder mehreren Substituenten substituiert ist, unabhängig ausgewählt aus der Gruppe bestehend aus Me, ⁱPr, ^{t}Bu, CN, CF₃ und Ph,
Triazinyl, das optional mit einem oder mehreren Substituenten substituiert ist, unabhängig ausgewählt aus der Gruppe bestehend aus Me, ⁱPr, ^{t}Bu, CN, CF₃ und Ph,
und N(Ph)₂.

4. Organisches Molekül nach einem der Ansprüche 1 bis 3, wobei R⁵ bei jedem Auftreten unabhängig ausgewählt ist aus der Gruppe bestehend aus:
Wasserstoff,
Me,
ⁱPr,
^{t}Bu,
CN,
CF₃,
Ph, das optional mit einem oder mehreren Substituenten substituiert ist, unabhängig ausgewählt aus der Gruppe bestehend aus Me, ⁱPr, ^{t}Bu, CN, CF₃und Ph,
Pyridinyl, das optional mit einem oder mehreren Substituenten substituiert ist, unabhängig ausgewählt aus der Gruppe bestehend aus Me, ⁱPr, ^{t}Bu, CN, CF₃ und Ph,
Pyrimidinyl, das optional mit einem oder mehreren Substituenten substituiert ist, unabhängig ausgewählt aus der Gruppe bestehend aus Me, ⁱPr, ^{t}Bu, CN, CF₃ und Ph,
Carbazolyl, das optional mit einem oder mehreren Substituenten substituiert ist, unabhängig ausgewählt aus der Gruppe bestehend aus Me, ⁱPr, ^{t}Bu, CN, CF₃ und Ph,
Triazinyl, das optional mit einem oder mehreren Substituenten substituiert ist, unabhängig ausgewählt aus der Gruppe bestehend aus Me, ⁱPr, ^{t}Bu, CN, CF₃ und Ph,
und N(Ph)₂.

5. Organisches Molekül nach einem der Ansprüche 1 bis 4, umfassend eine Struktur der Formel Ila-1: 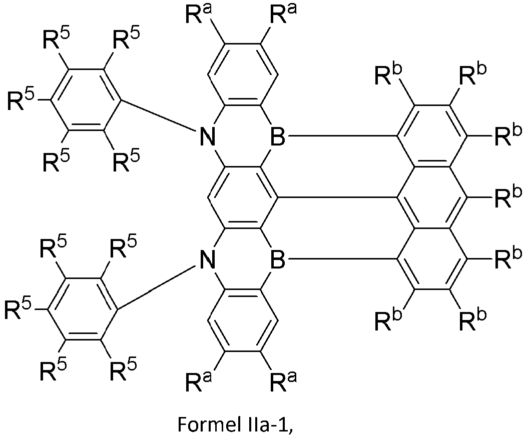 wobei in Formel Ila-1 R^{a}, R^{b}und R⁵ die gleichen sind wie in Zusammenhang mit Formel I beschrieben, und benachbarte R^{a}-Substituenten unabhängig ein mono- oder polycyclisches, aliphatisches, aromatisches oder heteroaromatisches und/oder benzokondensiertes Ringsystem bilden.

6. Organisches Molekül nach einem der Ansprüche 1 bis 5, umfassend eine Struktur der Formel V-1, Formel V-2 oder Formel V-3: 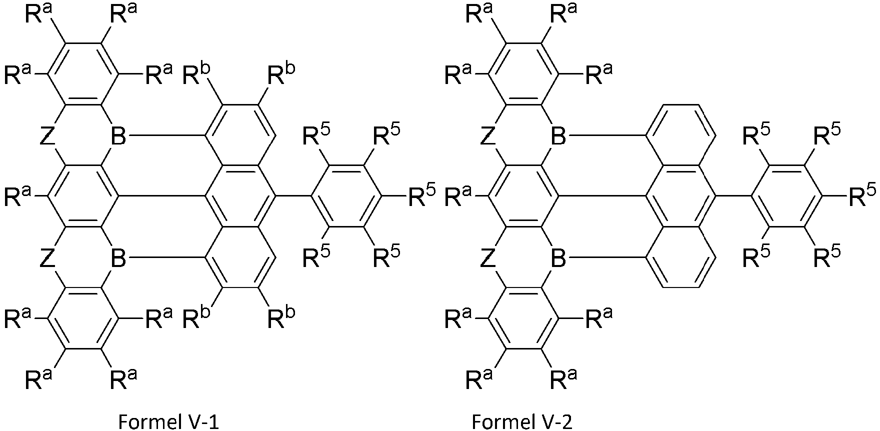 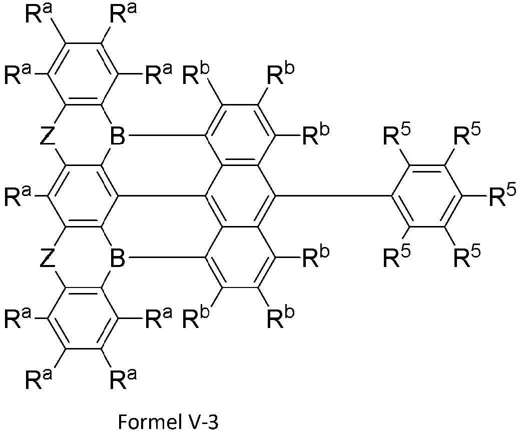 wobei in Formel V-1, Formel V-2 und Formel V-3 Z R^{a}, R^{b}und R⁵ die gleichen sind wie in Zusammenhang mit Formel I beschrieben.

7. Organisches Molekül nach einem der Ansprüche 1 bis 6, wobei R^{b} bei jedem Auftreten unabhängig ausgewählt ist aus der Gruppe bestehend aus:
Wasserstoff,
Me,
ⁱPr,
^{t}Bu,
CN,
CF₃,
Ph, das optional mit einem oder mehreren Substituenten substituiert ist, unabhängig ausgewählt aus der Gruppe bestehend aus Me, ⁱPr, ^{t}Bu, CN, CF₃und Ph,
Pyridinyl, das optional mit einem oder mehreren Substituenten substituiert ist, unabhängig ausgewählt aus der Gruppe bestehend aus Me, ⁱPr, ^{t}Bu, CN, CF₃ und Ph,
Pyrimidinyl, das optional mit einem oder mehreren Substituenten substituiert ist, unabhängig ausgewählt aus der Gruppe bestehend aus Me, ⁱPr, ^{t}Bu, CN, CF₃ und Ph,
Carbazolyl, das optional mit einem oder mehreren Substituenten substituiert ist, unabhängig ausgewählt aus der Gruppe bestehend aus Me, ⁱPr, ^{t}Bu, CN, CF₃ und Ph,
Triazinyl, das optional mit einem oder mehreren Substituenten substituiert ist, unabhängig ausgewählt aus der Gruppe bestehend aus Me, ⁱPr, ^{t}Bu, CN, CF₃ und Ph,
und N(Ph)₂.

8. Oligomer, umfassend eine Vielzahl organischer Moleküle nach einem der Ansprüche 1 bis 7 als Einheiten, wobei jede Einheit eine durch die Formel VI dargestellte Struktur umfasst oder daraus besteht 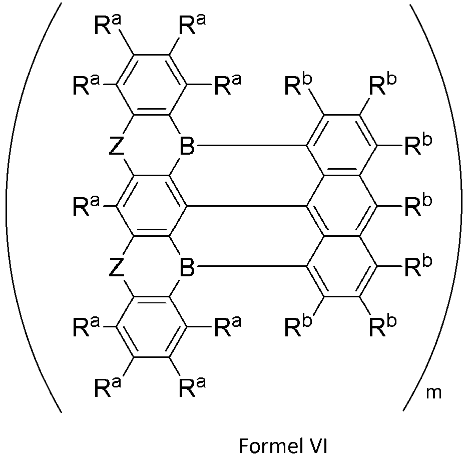 wobei in Formel VI Z, R^{a} und R^{b} die gleichen sind wie in Zusammenhang mit Formel I beschrieben und m eine ganze Zahl von 2 bis 6 ist.

9. Verwendung eines organischen Moleküls nach einem der Ansprüche 1 bis 8 als ein Lumineszenzemitter in einer optoelektronischen Vorrichtung.

10. Verwendung nach Anspruch 9, wobei die optoelektronische Vorrichtung ausgewählt ist aus der Gruppe bestehend aus:
- organischen licht emittierenden Dioden (OLEDs),
- lichtemittierenden elektrochemischen Zellen,
- OLED-Sensoren,
- organischen Dioden,
- organischen Solarzellen,
- organischen Transistoren,
- organischen Feldeffekttransistoren,
- organischen Lasern und
- Abwärtswandlungselementen.

11. Zusammensetzung, umfassend:
(a) ein organisches Molekül nach einem der Ansprüche 1 bis 8, insbesondere in Form eines Emitters und/oder eines Wirts,
b) einen Emitter und/oder ein Wirtsmaterial, das sich von dem organischen Molekül unterscheidet, und
(c) optional einen Farbstoff und/oder ein Lösungsmittel.

12. Optoelektronische Vorrichtung, umfassend ein organisches Molekül nach einem der Ansprüche 1 bis 8 oder eine Zusammensetzung nach Anspruch 11, insbesondere in Form einer Vorrichtung ausgewählt aus der Gruppe bestehend aus organischer lichtemittierender Diode (OLED), lichtemittierender elektrochemischer Zelle, OLED-Sensor, organischer Diode, organischer Solarzelle, organischem Transistor, organischem Feldeffekttransistor, organischem Laser und Abwärtswandlungselement.

13. Optoelektronische Vorrichtung nach Anspruch 12, umfassend:
- ein Substrat,
- eine Anode und
- eine Kathode, wobei die Anode oder die Kathode auf dem Substrat angeordnet ist, und
- eine lichtemittierende Schicht, die zwischen der Anode und der Kathode angebracht ist und die das organische Molekül oder die Zusammensetzung umfasst.

14. Verfahren zum Produzieren einer optoelektronischen Vorrichtung, wobei ein organisches Molekül nach einem der Ansprüche 1 bis 8 oder eine Zusammensetzung nach Anspruch 11 verwendet wird.

15. Verfahren nach Anspruch 14, umfassend das Verarbeiten des organischen Moleküls durch ein Vakuumverdampfungsverfahren oder aus einer Lösung.

## Revendications

1. Molécule organique, comprenant une structure de formule I : 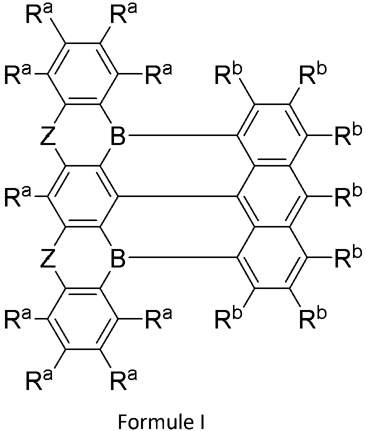
Z est, à chaque occurrence, sélectionné indépendamment dans le groupe consistant en une liaison directe, NR^{a}, O et S ; et
R^{a} et R^{b} sont, à chaque occurrence, sélectionnés indépendamment dans le groupe consistant en : hydrogène, deutérium, N(R⁵)₂, OR⁵, Si(R⁵)₃, B(OR⁵)₂, B(R⁵)₂, OSO₂R⁵, CF₃, CN, F, Br, I,
alkyle en C₁-C₄₀,
qui est éventuellement substitué par un ou plusieurs substituants R⁵ et
dans laquelle un ou plusieurs groupes CH₂ non adjacents sont éventuellement substitués par R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S ou CONR⁵;
alcoxy en C₁-C₄₀,
qui est éventuellement substitué par un ou plusieurs substituants R⁵ et
dans laquelle un ou plusieurs groupes CH₂ non adjacents sont éventuellement substitués par R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S ou CONR⁵;
thioalcoxy en C₁-C₄₀,
qui est éventuellement substitué par un ou plusieurs substituants R⁵ et
dans laquelle un ou plusieurs groupes CH₂ non adjacents sont éventuellement substitués par R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S ou CONR⁵;
alcényle en C₂-C₄₀,
qui est éventuellement substitué par un ou plusieurs substituants R⁵ et
dans laquelle un ou plusieurs groupes CH₂ non adjacents sont éventuellement substitués par R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S ou CONR⁵;
alcynyle en C₂-C₄₀,
qui est éventuellement substitué par un ou plusieurs substituants R⁵ et
dans laquelle un ou plusieurs groupes CH₂ non adjacents sont éventuellement substitués par R⁵C=CR⁵, C=C, Si(R⁵)₂, Ge(R⁵)₂, Sn(R⁵)₂, C=O, C=S, C=Se, C=NR⁵, P(=O)(R⁵), SO, SO₂, NR⁵, O, S ou CONR⁵;
aryle en C₆-C₆₀,
qui est éventuellement substitué par un ou plusieurs substituants R⁵ ; et hétéroaryle en C₂-C₅₇,
qui est éventuellement substitué par un ou plusieurs substituants R⁵ ;
R⁵ est, à chaque occurrence, sélectionné indépendamment dans le groupe consistant en : hydrogène, deutérium, N(R⁶)₂, OR⁶, Si(R⁶)₃, B(OR⁶)₂, B(R⁶)₂, OSO₂R⁶, CF₃, CN, F, Br, I,
alkyle en C₁-C₄₀,
qui est éventuellement substitué par un ou plusieurs substituants R⁶ et
dans laquelle un ou plusieurs groupes CH₂ non adjacents sont éventuellement substitués par R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ ;
alcoxy en C₁-C₄₀,
qui est éventuellement substitué par un ou plusieurs substituants R⁶ et
dans laquelle un ou plusieurs groupes CH₂ non adjacents sont éventuellement substitués par R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ ;
thioalcoxy en C₁-C₄₀,
qui est éventuellement substitué par un ou plusieurs substituants R⁶ et
dans laquelle un ou plusieurs groupes CH₂ non adjacents sont éventuellement substitués par R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ ;
alcényle en C₂-C₄₀,
qui est éventuellement substitué par un ou plusieurs substituants R⁶ et
dans laquelle un ou plusieurs groupes CH₂ non adjacents sont éventuellement substitués par R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ ;
alcynyle en C₂-C₄₀,
qui est éventuellement substitué par un ou plusieurs substituants R⁶ et
dans laquelle un ou plusieurs groupes CH₂ non adjacents sont éventuellement substitués par R⁶C=CR⁶, C=C, Si(R⁶)₂, Ge(R⁶)₂, Sn(R⁶)₂, C=O, C=S, C=Se, C=NR⁶, P(=O)(R⁶), SO, SO₂, NR⁶, O, S ou CONR⁶ ;
aryle en C₆-C₆₀,
qui est éventuellement substitué par un ou plusieurs substituants R⁶ ; et hétéroaryle en C₂-C₅₇,
qui est éventuellement substitué par un ou plusieurs substituants R⁶ ;
R⁶ est, à chaque occurrence, sélectionné indépendamment dans le groupe consistant en : hydrogène, deutérium, OPh, CF₃, CN, F,
alkyle en C₁-C₅,
dans laquelle un ou plusieurs atomes d'hydrogène sont éventuellement et indépendamment substitués par du deutérium, CN, CF₃ou F ;
alcoxy en C₁-C₅,
dans laquelle un ou plusieurs atomes d'hydrogène sont éventuellement et indépendamment substitués par du deutérium, CN, CF₃ou F ;
thioalcoxy en C₁-C₅,
dans laquelle un ou plusieurs atomes d'hydrogène sont éventuellement et indépendamment substitués par du deutérium, CN, CF₃ou F ;
alcényle en C₂-C₅,
dans laquelle un ou plusieurs atomes d'hydrogène sont éventuellement et indépendamment substitués par du deutérium, CN, CF₃ou F ;
alcynyle en C₂-C₅,
dans laquelle un ou plusieurs atomes d'hydrogène sont éventuellement et indépendamment substitués par du deutérium, CN, CF₃ou F ;
aryle en C₆-C₁₈,
qui est éventuellement substitué par un ou plusieurs substituants alkyle en C₁-C₅ ;
hétéroaryle en C₂-C₁₇,
qui est éventuellement substitué par un ou plusieurs substituants alkyle en C₁-C₅ ;
N(aryle en C₆-C₁₈)₂;
N(hétéroaryle en C₂-C₁₇)₂et
N(hétéroaryle en C₂-C₁₇)(aryle en C₆-C₁₈) ;
dans laquelle éventuellement n'importe lesquels des substituants R^{a}, R^{b}, R⁵, et R⁶ forment indépendamment un système cyclique mono- ou polycyclique, aliphatique, aromatique hétéroaromatique et/ou benzo-fusionné avec un ou plusieurs substituants R^{a}, R^{b}, R⁵ et/ou R⁶.

2. Molécule organique selon la revendication 1, comprenant une structure de formule II-1 ou de formule II-2 : 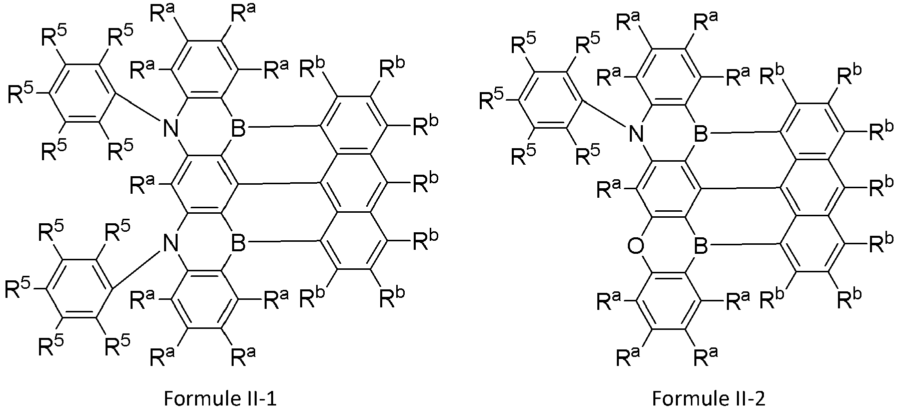 dans laquelle, dans la formule II-1 et la formule II-2, R^{a}, R^{b}, et R⁵ sont identiques à ceux décrits en relation avec la formule I.

3. Molécule organique selon les revendications 1 ou 2, dans laquelle R⁵ est, à chaque occurrence, choisi indépendamment dans le groupe consistant en :
hydrogène,
Me,
ⁱPr,
^{t}Bu,
CN,
CF₃,
Ph, qui est éventuellement substitué par un ou plusieurs substituants choisis indépendamment dans le groupe consistant en Me, ⁱPr, ^{t}Bu, CN, CF₃, et Ph,
pyridinyle, qui est éventuellement substitué par un ou plusieurs substituants choisis indépendamment dans le groupe consistant en Me, ⁱPr, ^{t}Bu, CN, CF₃, et Ph,
pyrimidinyle, qui est éventuellement substitué par un ou plusieurs substituants choisis indépendamment dans le groupe consistant en Me, ⁱPr, ^{t}Bu, CN, CF₃, et Ph,
carbazolyle, qui est éventuellement substitué par un ou plusieurs substituants choisis indépendamment dans le groupe consistant en Me, ⁱPr, ^{t}Bu, CN, CF₃, et Ph,
triazinyle, qui est éventuellement substitué par un ou plusieurs substituants choisis indépendamment dans le groupe consistant en Me, ⁱPr, ^{t}Bu, CN, CF₃, et Ph,
et N(Ph)₂.

4. Molécule organique selon l'une quelconque des revendications 1 à 3, dans laquelle R⁵ est, à chaque occurrence, choisi indépendamment dans le groupe consistant en :
hydrogène,
Me,
ⁱPr,
^{t}Bu,
CN,
CF₃,
Ph, qui est éventuellement substitué par un ou plusieurs substituants choisis indépendamment dans le groupe consistant en Me, ⁱPr, ^{t}Bu, CN, CF₃, et Ph,
pyridinyle, qui est éventuellement substitué par un ou plusieurs substituants choisis indépendamment dans le groupe consistant en Me, ⁱPr, ^{t}Bu, CN, CF₃, et Ph,
pyrimidinyle, qui est éventuellement substitué par un ou plusieurs substituants choisis indépendamment dans le groupe consistant en Me, ⁱPr, ^{t}Bu, CN, CF₃, et Ph,
carbazolyle, qui est éventuellement substitué par un ou plusieurs substituants choisis indépendamment dans le groupe consistant en Me, ⁱPr, ^{t}Bu, CN, CF₃, et Ph,
triazinyle, qui est éventuellement substitué par un ou plusieurs substituants choisis indépendamment dans le groupe consistant en Me, ⁱPr, ^{t}Bu, CN, CF₃, et Ph,
et N(Ph)₂.

5. Molécule organique selon l'une quelconque des revendications 1 à 4, comprenant une structure de formule Ila-1 : 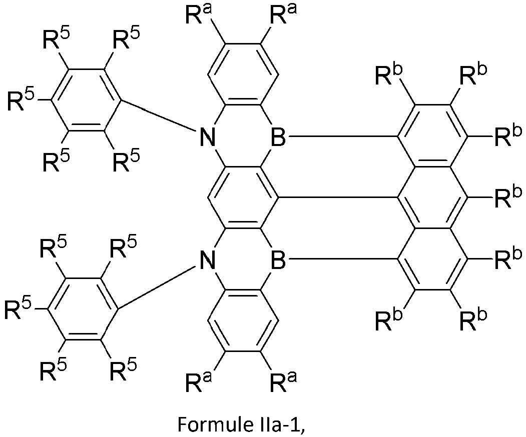 dans laquelle, dans la formule Ila-1, R^{a}, R^{b}et R⁵ sont identiques à ceux décrits en relation avec la formule I, et les substituants R^{a} adjacents forment indépendamment un cycle mono- ou polycyclique, aliphatique, aromatique ou hétéroaromatique et/ou un système cyclique benzo-fusionné.

6. Molécule organique selon l'une quelconque des revendications 1 à 5, comprenant une structure de formule V-1, de formule V-2 ou de formule V-3 : 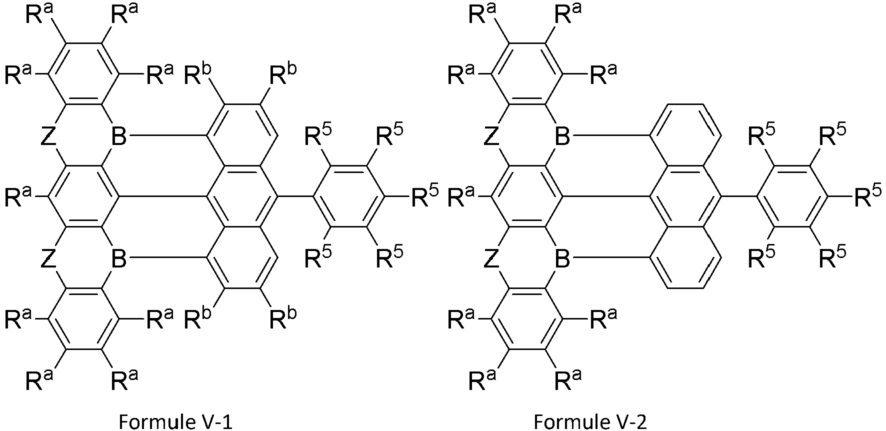 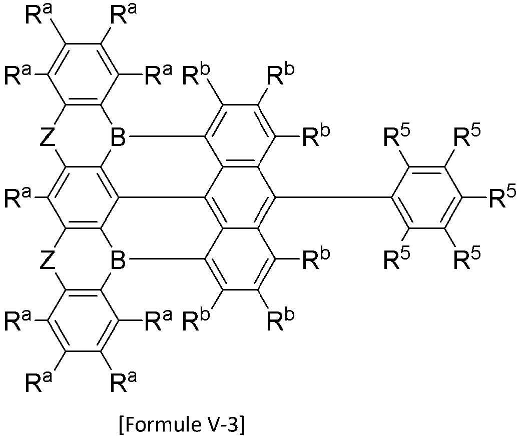 dans laquelle, dans la formule V-1, la formule V-2 et la formule V-3, Z, R^{a}, R^{b}et R⁵ sont identiques à ceux décrits en relation avec la formule I.

7. Molécule organique selon l'une quelconque des revendications 1 à 6, dans laquelle R^{b} est, à chaque occurrence, choisi indépendamment dans le groupe consistant en :
hydrogène,
Me,
ⁱPr,
^{t}Bu,
CN,
CF₃,
Ph, qui est éventuellement substitué par un ou plusieurs substituants choisis indépendamment dans le groupe consistant en Me, ⁱPr, ^{t}Bu, CN, CF₃, et Ph,
pyridinyle, qui est éventuellement substitué par un ou plusieurs substituants choisis indépendamment dans le groupe consistant en Me, ⁱPr, ^{t}Bu, CN, CF₃, et Ph,
pyrimidinyle, qui est éventuellement substitué par un ou plusieurs substituants choisis indépendamment dans le groupe consistant en Me, ⁱPr, ^{t}Bu, CN, CF₃, et Ph,
carbazolyle, qui est éventuellement substitué par un ou plusieurs substituants choisis indépendamment dans le groupe consistant en Me, ⁱPr, ^{t}Bu, CN, CF₃, et Ph,
triazinyle, qui est éventuellement substitué par un ou plusieurs substituants choisis indépendamment dans le groupe consistant en Me, ⁱPr, ^{t}Bu, CN, CF₃, et Ph,
et N(Ph)₂.

8. Oligomère comprenant une pluralité de molécules organiques selon l'une quelconque des revendications 1 à 7, dans lequel chaque unité comprend ou consiste en une structure représentée par la formule VI 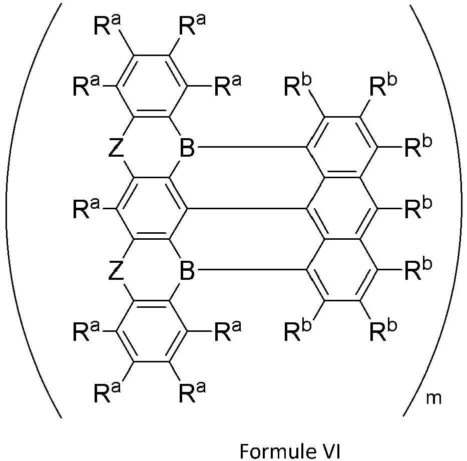 dans lequel, dans la formule VI, Z, R^{a}et R^{b} sont identiques à ceux décrits en relation avec la formule I, et m est un entier de 2 à 6.

9. Utilisation d'une molécule organique selon l'une quelconque des revendications 1 à 8 comme émetteur luminescent dans un dispositif optoélectronique.

10. Utilisation selon la revendication 9, dans laquelle le dispositif optoélectronique est choisi dans le groupe consistant en :
- diodes électroluminescentes organiques (OLED),
- cellules électrochimiques émettrices de lumière,
- Capteurs OLED,
- diodes organiques,
- cellules solaires organiques,
- transistors organiques,
- transistors organiques à effet de champ,
- lasers organiques, et
- éléments de conversion descendante.

11. Composition, comprenant :
(a) une molécule organique selon l'une quelconque des revendications 1 à 8, notamment sous la forme d'un émetteur et/ou d'un hôte,
(b) un émetteur et/ou un matériau hôte, qui diffère de la molécule organique, et
(c) éventuellement, un colorant et/ou un solvant.

12. Dispositif optoélectronique comprenant une molécule organique selon l'une quelconque des revendications 1 à 8 ou une composition selon la revendication 11, notamment sous la forme d'un dispositif choisi dans le groupe consistant en diode électroluminescente organique (OLED), cellule électrochimique électroluminescente, capteur OLED, diode organique, cellule solaire organique, transistor organique, transistor organique à effet de champ, laser organique et élément de conversion descendante.

13. Dispositif optoélectronique selon la revendication 12, comprenant :
- un substrat,
- une anode, et
- une cathode, dans lequel l'anode ou la cathode est disposée sur le substrat, et
- une couche émettrice de lumière, qui est agencée entre l'anode et la cathode et qui comprend la molécule organique ou la composition.

14. Procédé de production d'un dispositif optoélectronique, dans lequel une molécule organique selon l'une quelconque des revendications 1 à 8 ou une composition selon la revendication 11 est utilisée.

15. Procédé selon la revendication 14, comprenant le traitement de la molécule organique par un procédé d'évaporation sous vide ou à partir d'une solution.
